(19) Europäisches Patentamt / European Patent Office / Office européen des brevets

(11) EP 3 406 640 A1

(12) EUROPEAN PATENT APPLICATION
published in accordance with Art. 153(4) EPC

(43) Date of publication:
**28.11.2018 Bulletin 2018/48**

(21) Application number: **17741447.1**

(22) Date of filing: **18.01.2017**

(51) Int Cl.:
***C08F 220/24*** (2006.01) ***C08F 220/26*** (2006.01)
***C08K 3/16*** (2006.01) ***C08K 5/42*** (2006.01)
***C08L 33/14*** (2006.01) ***C12M 1/00*** (2006.01)
***G03F 7/039*** (2006.01)

(86) International application number:
**PCT/JP2017/001602**

(87) International publication number:
**WO 2017/126570 (27.07.2017 Gazette 2017/30)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA MD**

(30) Priority: **19.01.2016 JP 2016007734**
**25.04.2016 JP 2016087044**
**08.07.2016 JP 2016136414**

(71) Applicant: **AGC INC.**
**Chiyoda-ku,**
**Tokyo 1008405 (JP)**

(72) Inventors:
- **OBI Masaki**
**Tokyo 100-8405 (JP)**
- **SAKURADA Tomoaki**
**Tokyo 100-8405 (JP)**
- **TANIGUCHI Taihei**
**Tokyo 100-8405 (JP)**
- **SASAKI Miyako**
**Tokyo 100-8405 (JP)**

(74) Representative: **Müller-Boré & Partner**
**Patentanwälte PartG mbB**
**Friedenheimer Brücke 21**
**80639 München (DE)**

# (54) PHOTOSENSITIVE RESIN COMPOSITION FOR BIOCHIP AND METHOD FOR FORMING LIQUID-REPELLENT FILM

(57) To provide e.g. a photosensitive resin composition for a biochip, capable of forming a liquid repellent film at a high resolution, with an aqueous alkaline solution, without performing PEB treatment, a method for forming the liquid repellent film, a process for producing a biochip.

A photosensitive resin composition for a biochip, which comprises the following polymer (A), or comprises the following polymer (B) and the following polymer (C), wherein the proportion of the following unit (u2) is from 35 to 97 mol% to the total number of units constituting the composition,

Unit (u2): a unit represented by the following formula (II):

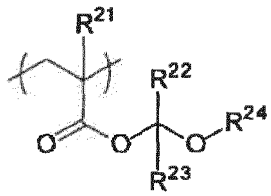

(II)

($R^{21}$: a hydrogen atom or a methyl group, $R^{22}$: an alkyl group or the like, $R^{23}$: a hydrogen atom or the like, $R^{24}$: an alkyl group, a cycloalkyl group or the like)

Polymer (A): a polymer having a unit (u1) which has an organic group having at least one fluorine atom, and the unit (u2),

Polymer (B): a polymer having the unit (u1) which has an organic group having at least one fluorine atom, other than the polymer (A),

EP 3 406 640 A1

Polymer (C): a polymer having the unit (u2), other than the polymer (A).

Fig. 1

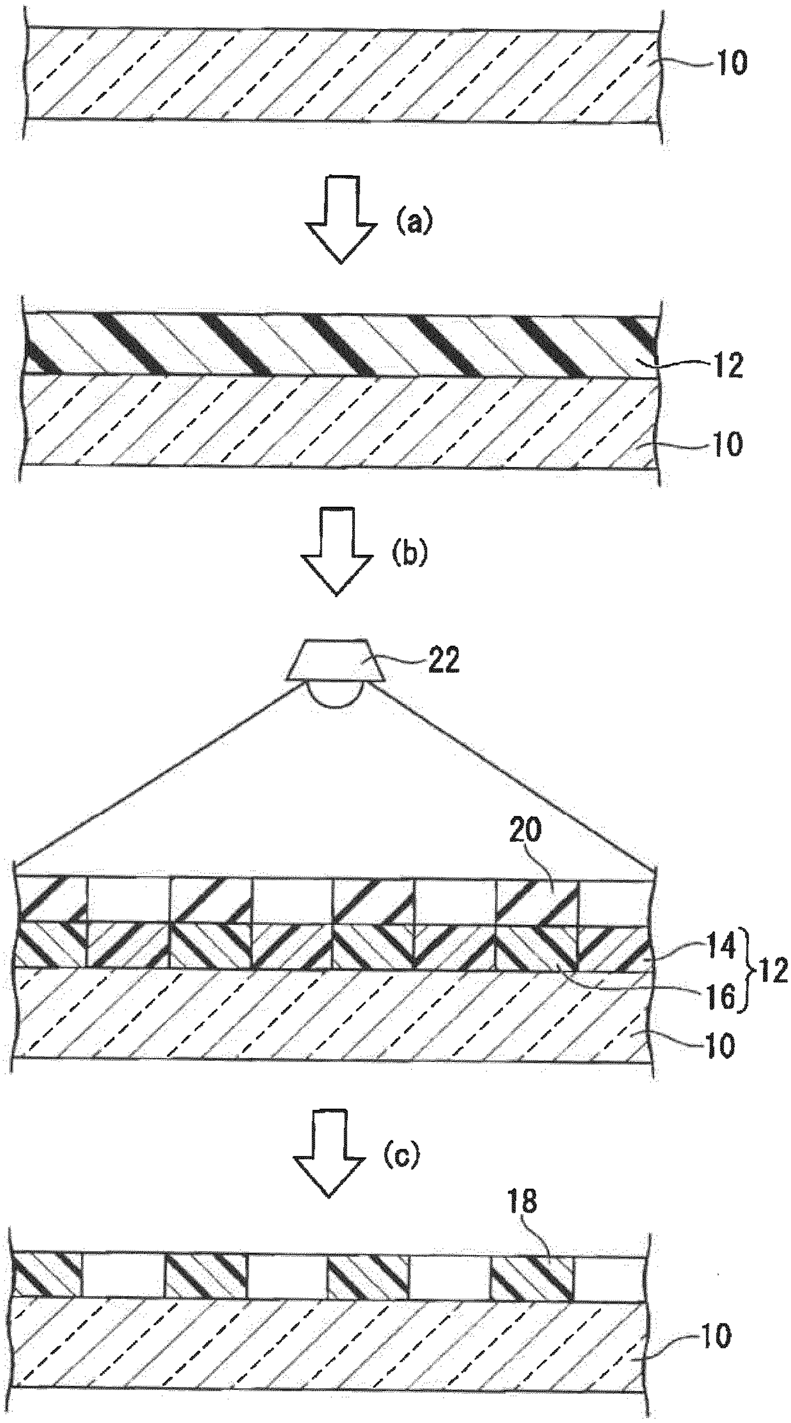

**Description**

TECHNICAL FIELD

The present invention relates to a polymer having a liquid repellent group and an acid-dissociable group, a photosensitive resin composition for a biochip, a method for forming a liquid repellent film having a predetermined pattern by using the photosensitive resin composition for a biochip, and a process for producing a biochip.

BACKGROUND ART

As a member or device having a patterned liquid repellent film, the following (1) to (3) are known.

(1) A biochip in which a liquid repellent film having receptacles (pores) for storing beads capturing target molecules is formed on the surface of a lyophilic substrate (Patent Document 1).
(2) A pixel forming substrate having a liquid repellent bank material serving as a partition between respective pixels at the time of forming the pixels for e.g. a color filter or an organic EL device, by an inkjet method (Patent Document 2).
(3) An electrowetting device utilizing an electrowetting effect of reducing a contact angle of a liquid droplet by a potential difference between a liquid repellent insulating membrane formed on the surface of an electrode and the liquid droplet placed on the liquid repellent insulating membrane (Patent Document 3).

The liquid repellent film in the biochip of the above (1) and the liquid repellent insulating membrane in the electrowetting device of the above (3) are formed by photolithography and etching (see paragraphs [0109] to [0115] of Patent Document 1 and paragraph [0083] of Patent Document 3). Therefore, it takes time and effort to form the liquid repellent film and the liquid repellent insulating membrane.

The liquid repellent bank material in the substrate of the above (2) is formed by photolithography using a liquid repellent photosensitive composition. A photosensitive film made of a liquid repellent photosensitive composition patterned by the photolithography is available as it is as a liquid repellent bank material, and therefore an etching step is unnecessary. However, since the photosensitive composition is of a negative type, there are problems peculiar to photolithography using a negative type photosensitive composition, such as a low resolution.

As a method for forming a liquid repellent film patterned by photolithography using a positive photosensitive composition, the following (4) has been proposed.

(4) A method for forming a liquid repellent film having a predetermined pattern, by coating the surface of a substrate with a photosensitive composition containing a fluorine-based polymer having an acid-dissociable group, a photoacid generator and a solvent, to form a photosensitive film, exposing the photosensitive film through a mask, and developing the predetermined-patterned photosensitive film with an aqueous alkaline solution (paragraph [0050] of Patent Document 4).

PRIOR ART DOCUMENTS

PATENT DOCUMENTS

Patent Document 1: WO 2012/121310
Patent Document 2: WO 2011/081149
Patent Document 3: WO 2013/129503
Patent Document 4: WO 2006/129800

DISCLOSURE OF INVENTION

TECHNICAL PROBLEM

However, the method of the above (4) has the following problems.

- It is difficult to dissociate a tert-butyl group from a tert-butoxycarbonyl group as an acid-dissociable group. Accordingly, unless PEB (Post Exposure Bake) treatment is performed after exposure and before development of the photosensitive film, the tert-butyl group fails to dissociate to form a carboxy group, and it is therefore impossible to carry out

development of the photosensitive film with an aqueous alkaline solution (paragraph [0136] in Patent Document 4).

- Further, according to the PEB treatment, an acid generated from the photo-acid generator by the exposure may also diffuse to an unexposed area, whereupon the unexposed area may also be developed, and therefore the resolution may be lowered.
- Even if the acid-dissociable group is replaced with another group in order to omit the PEB treatment, the aqueous alkaline solution is less likely to be infiltrated into the liquid repellent photosensitive film containing the fluorine-based polymer during the development. Therefore, development failure may occur and the resolution would be insufficient.

It is an object of the present invention to provide a photosensitive resin composition for a biochip, capable of forming a liquid repellent film having a predetermined pattern at a high resolution, by development with an aqueous alkaline solution without performing PEB treatment, a method for forming a liquid repellent film and a process for producing a biochip, and a polymer capable of obtaining such a photosensitive resin composition.

SOLUTION TO PROBLEM

The present invention provides the following embodiments.

[1] A photosensitive resin composition for a biochip, which comprises the following polymer (A), or comprises the following polymer (B) and the following polymer (C), wherein the proportion of the following unit (u2) is from 35 to 97 mol% to the total number of units constituting the composition,

Unit (u2): a unit represented by the following formula (II):

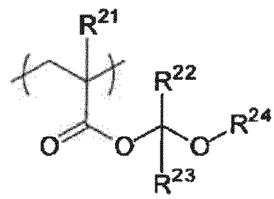

(II)

wherein $R^{21}$ is a hydrogen atom or a methyl group, $R^{22}$ is an alkyl group or a cycloalkyl group, $R^{23}$ is a hydrogen atom, an alkyl group or a cycloalkyl group, $R^{24}$ is an alkyl group in which one or more of hydrogen atoms may be substituted, a cycloalkyl group in which one or more of hydrogen atoms may be substituted, or an aralkyl group in which one or more of hydrogen atoms may be substituted, and $R^{22}$ and $R^{24}$ may be linked with each other to form a cyclic ether,

Polymer (A): a polymer having a unit (u1) which has an organic group having at least one fluorine atom, and the unit (u2),

Polymer (B): a polymer having the unit (u1) which has an organic group having at least one fluorine atom, other than the polymer (A),

Polymer (C): a polymer having the unit (u2), other than the polymer (A).

[2] The photosensitive resin composition for a biochip according to [1], wherein the unit (u1) is a unit represented by the following formula (I):

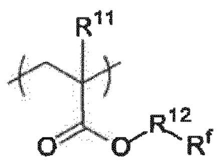

(I)

wherein $R^{11}$ is a hydrogen atom, a methyl group or a halogen atom, $R^{12}$ is an alkylene group, $R^f$ is a $C_{4-6}$ perfluoroalkyl group or a $C_{4-6}$ perfluoroalkyl group having an etheric oxygen atom between the carbon atoms.

[3] The photosensitive resin composition for a biochip according to [1] or [2], which comprises the following polymer (A'), comprises the following polymer (B') and the following polymer (C'), comprises the following polymer (B') and the above polymer (C), comprises the above polymer (B) and the following polymer (C'), or comprises the above polymer (B), the above polymer (C) and the following polymer (D),

Polymer (A'): a polymer having the above unit (u1), the above unit (u2) and the following unit (u3),
Polymer (B'): a polymer having the above unit (u1) and the following unit (u3), other than the polymer (A'),
Polymer (C'): a polymer having the above unit (u2) and the following unit (u3), other than the polymer (A'),
Polymer (D): a polymer having the following unit (u3), other than the polymer (A'), the polymer (B') and the polymer (C'),
Unit (u3): a unit having a cyclic ether.

[4] The photosensitive resin composition for a biochip according to [3], wherein the unit (u3) is a unit represented by the following formula (III):

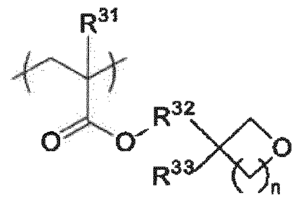

(III)

wherein $R^{31}$ is a hydrogen atom or a methyl group, $R^{32}$ is an alkylene group, $R^{33}$ is a hydrogen atom or an alkyl group, and n is 0 or 1.
[5] The photosensitive resin composition for a biochip according to [3] or [4], which contains the above polymer (A').
[6] A polymer comprising a unit (u1) which has an organic group having at least one fluorine atom, and a unit (u2) represented by the following formula (II), wherein the proportion of the unit (u2) is from 35 to 97 mol% to the total units,

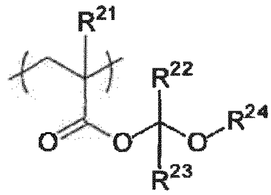

(II)

wherein $R^{21}$ is a hydrogen atom or a methyl group, $R^{22}$ is an alkyl group or a cycloalkyl group, $R^{23}$ is a hydrogen atom, an alkyl group or a cycloalkyl group, $R^{24}$ is an alkyl group in which one or more of hydrogen atoms may be substituted, a cycloalkyl group in which one or more of hydrogen atoms may be substituted, or an aralkyl group in which one or more of hydrogen atoms may be substituted, and $R^{22}$ and $R^{24}$ may be linked to form a cyclic ether.
[7] The polymer according to [6], wherein the above unit (u1) is a unit represented by the following formula (I):

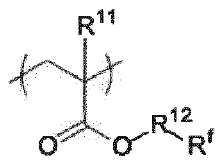

(I)

wherein $R^{11}$ is a hydrogen atom, a methyl group or a halogen atom, $R^{12}$ is an alkylene group, $R^f$ is a $C_{4-6}$ perfluoroalkyl group or a $C_{4-6}$ perfluoroalkyl group having an etheric oxygen atom between the carbon atoms.
[8] The polymer according to [6] or [7], wherein the proportion of the above unit (u2) is from 35 to 97 mol% to the total units of the polymer.
[9] The polymer according to any one of [6] to [8], which further contains a unit (u3) having a cyclic ether.
[10] The polymer according to [9], wherein the above unit (u3) is a unit represented by the following formula (III):

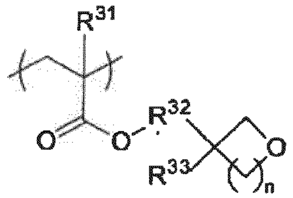

(III)

wherein $R^{31}$ is a hydrogen atom or a methyl group, $R^{32}$ is an alkylene group, $R^{33}$ is a hydrogen atom or an alkyl group, and n is 0 or 1.

[11] The polymer according to [9] or [10], wherein the proportion of the above unit (u1) is from 3 to 50 mol%, the proportion of the above unit (u2) is from 35 to 75 mol%, and the proportion of the above unit (u3) is from 1 to 60 mol%, to the total units of the polymer.

[12] The polymer according to any one of [6] to [11], which has a group represented by the following formula (IV), at either one or both of main chain terminals,

$$-S-CR^1R^2R^3 \quad (IV)$$

wherein $R^1$ and $R^2$ are each independently a hydrogen atom or an alkyl group in which one or more of hydrogen atoms may be substituted, $R^3$ is an alkyl group in which one or more of hydrogen atoms may be substituted, a cycloalkyl group in which one or more of hydrogen atoms may be substituted, an aryl group in which one or more of hydrogen atoms may be substituted, or a heteroaryl group in which one or more of hydrogen atoms may be substituted, and two or three of $R^1$ to $R^3$ may be linked with one another to form a ring structure.

[13] The polymer according to any one of [6] to [12], which has a mass average molecular weight of from 5,000 to 200,000.

[14] The photosensitive resin composition for a biochip according to any one of the above [1] to [5], which further contains a photo-acid generator.

[15] The photosensitive resin composition for a biochip according to [14], wherein the above photo-acid generator is a photo-acid generator having an absorption coefficient at a wavelength of 365 nm of at most 400 $mL \cdot g^{-1} \cdot cm^{-1}$.

[16] A method for forming a liquid repellent film, which comprises coating the surface of a substrate with the photosensitive resin composition for a biochip as defined in [14] or

[15] to form a photosensitive film, exposing the photosensitive film to form a latent image having a predetermined pattern, and developing the photosensitive film having the latent image formed, with an aqueous alkaline solution, to form the liquid repellent film having the predetermined pattern.

[17] A process for producing a biochip having a lyophilic substrate and a liquid repellent film which is provided on the surface of the lyophilic substrate and has a plurality of pores penetrating in the thickness direction,

which comprises coating the surface of the lyophilic substrate with the photosensitive resin composition as defined in the above [14] or [15] to form a photosensitive film, exposing a site corresponding to the pores of the photosensitive film, and developing the photosensitive film exposed, with an aqueous alkaline solution, to form the above liquid repellent film.

[18] The process for producing a biochip according to the above [17], wherein the aqueous alkaline solution for development has a surface tension of at most 60 mN/m.

ADVANTAGEOUS EFFECTS OF INVENTION

By using the polymer of the present invention, it is possible to obtain a photosensitive resin composition capable of forming a liquid repellent film having a predetermined pattern at a high resolution, by development with an aqueous alkaline solution without performing PEB treatment.

According to the photosensitive resin composition for a biochip of the present invention, it is possible to form a liquid repellent film having a predetermined pattern at a high resolution, by development with an aqueous alkaline solution without performing PEB treatment.

According to the pattern formation method of the present invention, it is possible to form a liquid repellent film having a predetermined pattern at a high resolution, by development with an aqueous alkaline solution without performing PEB treatment. According to the process for producing a biochip of the present invention, it is possible to form a liquid repellent film having a predetermined pattern at a high resolution, by development with an aqueous alkaline solution without performing PEB treatment.

BRIEF DESCRIPTION OF DRAWINGS

Fig. 1 is a diagram schematically explaining each step in a method for forming the liquid repellent film of the present invention as an example.

DESCRIPTION OF EMBODIMENTS

Meanings of the following terms in this specification are as follows.
A "perfluoroalkyl group" means a group in which all hydrogen atoms in an alkyl group are substituted by fluorine atoms.
A "photo-acid generator" means a compound that generates an acid upon irradiation with light.
A "liquid repellent film" means a film exhibiting liquid repellency as compared with a part other than the film, specifically, a film in which a contact angle of a predetermined liquid is larger than the part other than the film.
A "lyophilic substrate" means a substrate exhibiting lyophilic property as compared with a liquid repellent film, specifically, a substrate in which a contact angle of a predetermined liquid is smaller than the part other than the liquid repellent film.
An "acid-dissociable group" means a group a part of which is dissociable under the action of an acid and is thereby convertible into an acidic group.
A "halogen atom" means a fluorine atom, a chlorine atom or the like.
A "(meth)acryloyloxy group" is a generic term for an acryloyloxy group and a methacryloyloxy group.
A "(meth)acrylate" is a generic term for an acrylate and a methacrylate.
A "(meth)acrylic acid" is a generic term for "acrylic acid" and "methacrylic acid".
"Light" is a generic term for ultraviolet light, visible light, infrared light, electron beam and radiation.
An "absorption coefficient at a wavelength of 365 nm" is a value calculated by the formula based on Lambert-Beer's law, from the relation between the concentration and the absorbance, of a methanol solution containing a photo-acid generator at a concentration of from 0.001 to 0.1 mass%.
The photosensitive resin composition for a biochip of the present invention (hereinafter, referred to also as a "photosensitive resin composition") contains a polymer (A) or contains a polymer (B) and a polymer (C). The polymer (A) is a polymer having a unit (u1) which has an organic group having at least one fluorine atom, and a unit (u2) represented by the formula (II). The polymer (B) is a polymer having the unit (u1) which has an organic group having at least one fluorine atom, other than the polymer (A). The polymer (C) is a polymer having the unit (u2) represented by the formula (II), other than the polymer (A).

[Polymer (A)]

The polymer (A) has a specific unit (u1) and a specific unit (u2). As the case requires, the polymer (A) may also have a specific unit (u3) or a unit (u4) other than the unit (u1), the unit (u2) and the unit (u3).

(Unit (u1))

The unit (u1) is a unit which has an organic group having at least one fluorine atom. The polymer (A), which has the unit (u1), can exhibit liquid repellency when formed into a film.
The unit (u1) is preferably a unit which has a perfluoroalkyl group or a unit which has a perfluoroalkyl group having an etheric oxygen atom between the carbon atoms, with a view to sufficiently impart the liquid repellency to the liquid repellent film.
The number of carbon atoms in the perfluoroalkyl group or the perfluoroalkyl group having an etheric oxygen atom between the carbon atoms, is preferably an integer of at least 4, with a view to sufficiently imparting the liquid repellency to the liquid repellent film. It is preferably an integer of at most 6, from the viewpoint of being less influence on the environment. The number of carbon atoms is more preferably an integer of from 4 to 6, particularly preferably 6. The perfluoroalkyl group may be linear or branched, preferably linear.
With a view to sufficiently imparting the liquid repellency to the liquid repellent film, from the viewpoint of being less influence on the environment, and from the viewpoint of availability of a monomer as raw materials, the unit (u1) is preferably a unit represented by the following formula (I):

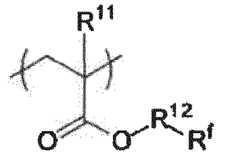

(I)

wherein $R^{11}$, $R^{12}$ and $R^f$ are as defined above.

Among them, $R^{11}$ is preferably a hydrogen atom or a methyl group. $R^{12}$ is preferably a linear or branched $C_{1-6}$ alkylene group, particularly preferably $-CH_2-$ or$-C_2H_4-$. Further, $R^f$ is preferably $-(CF_2)_3CF_3$, $-(CF_2)_4CF_3$, $-(CF_2)_5CF_3$,$-CF(CF_3)OCF_2CF_2CF_3$, $-CF_2OCF_2CF_2OCF_3$, $-CF_2OCF_2CF_2OCF_2CF_3$ or$-CF_2OCF_2CF_2OCF_2CF_2OCF_3$.

The unit represented by the formula (I) is a unit derived from a monomer (m1) represented by $CH_2=C(R^{11})C(O)OCR^{12}R^f$. The monomer (m1) may, for example, be the following compound.

$CH_2=C(CH_3)C(O)O-C_2H_4-(CF_2)_3CF_3$,
$CH_2=C(CH_3)C(O)O-C_2H_4-(CF_2)_4CF_3$,
$CH_2=C(CH_3)C(O)O-C_2H_4-(CF_2)_5CF_3$,
$CH_2=C(CH_3)C(O)O-CH_2-CF(CF_3)OCF_2CF_2CF_3$,
$CH_2=C(CH_3)C(O)O-CH_2-CF_2OCF_2CF_2OCF_3$,
$CH_2=C(CH_3)C(O)O-CH_2-CF_2OCF_2CF_2OCF_2CF_3$,
$CH_2=C(CH_3)C(O)O-CH_2-CF_2OCF_2CF_2OCF_2CF_2OCF_3$
$CH_2=CHC(O)O-C_2H_4-(CF_2)_3CF_3$,
$CH_2=CH C(O)O-C_2H_4-(CF_2)_4CF_3$,
$CH_2=CHC(O)O-C_2H_4-(CF_2)_5CF_3$,
$CH_2=CHC(O)O-CH_2-CF(CF_3)OCF_2CF_2CF_3$,
$CH_2=CHC(O)O-CH_2-CF_2OCF_2CF_2OCF_3$,
$CH_2=CHC(O)O-CH_2-CF_2OCF_2CF_2OCF_2CF_3$,
$CH_2=CHC(O)O-CH_2-CF_2OCF_2CF_2OCF_2CF_2OCF_3$,
$CH_2=C(Cl)C(O)O-C_2H_4-(CF_2)_3CF_3$,
$CH_2=C(Cl)C(O)O-C_2H_4-(CF_2)_4CF_3$,
$CH_2=C(Cl)C(O)O-C_2H_4-(CF_2)_5CF_3$.

With a view to sufficiently imparting liquid repellency to the liquid repellent film, from the viewpoint of being less influence on the environment, and from the viewpoint of availability of a monomer as raw materials, the monomer (m1) is particularly preferably the following compound.

$CH_2=C(CH_3)C(O)O-C_2H_4-(CF_2)_5CF_3$,
$CH_2=C(CH_3)C(O)O-CH_2-CF_2OCF_2CF_2OCF_3$.

As the monomer (m1), one type may be used alone, or two or more types may be used in combination.

(Unit (u2))

The unit (u2) is a unit represented by the following formula (II):

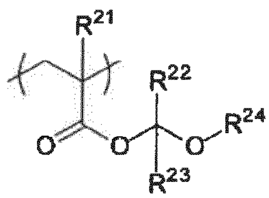

(II)

wherein $R^{21}$, $R^{22}$, $R^{23}$ and $R^{24}$ are as defined above.

Among them, $R^{21}$ is preferably a hydrogen atom or a methyl group. $R^{22}$ is preferably a linear or branched $C_{1-6}$ alkyl group or a $C_{3-6}$ cycloalkyl group, and it is particularly preferably a methyl group from the viewpoint of availability of a monomer as a raw material. $R^{23}$ is preferably a hydrogen atom, a linear or branched $C_{1-6}$ alkyl group or a $C_{3-6}$ cycloalkyl group, and it is particularly preferably a hydrogen atom from the viewpoint of availability of a monomer as a raw material.

$R^{24}$ is preferably a linear or branched $C_{1-10}$ alkyl group, a $C_{3-10}$ cycloalkyl group or a $C_{7-10}$ aralkyl group.

When $R^{22}$ and $R^{24}$ are linked to form a cyclic ether, it is preferred that $R^{22}$ and $R^{24}$ are bonded to form a $C_{2-5}$ alkylene group. In a case where one or more of hydrogen atoms in the alkyl group, the cycloalkyl group or the aralkyl group in $R^{24}$ are substituted, the substituent may, for example, be a $C_{1-6}$ alkyl group, a $C_{1-6}$ alkoxy group or a halogen atom.

Since the polymer (A) has the unit (u2), it is possible to develop a photosensitive film containing the polymer (A) with an alkali developer without performing PEB treatment after exposing the photosensitive film. That is, in the unit (u2), an acid-dissociable group is hydrolyzed by an acid generated from a photo-acid generator by the exposure to produce a carboxy group, as shown in the following formula.

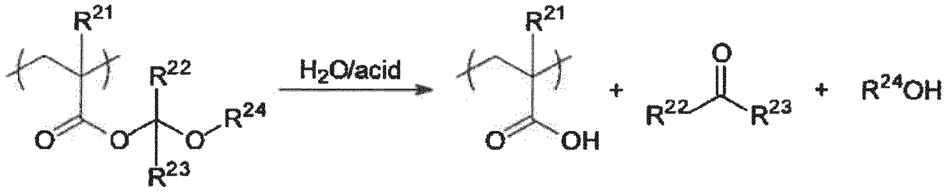


The acid-dissociable group represented by $-C(O)OC(R^{22})(R^{23})OR^{24}$ in the above formula (II), which has a lower activation energy for acid decomposition than a tert-butoxycarbonyl group ($-C(O)OC(CH_3)_3$) as a conventional acid-dissociable group, is readily hydrolyzed by an acid generated from the photo-acid generator, thereby to form a carboxy group. Accordingly, it is possible to develop a photosensitive film containing the polymer (A) with an alkali developer without performing PEB treatment after exposure.

The unit (u2) is a unit derived from the monomer (m2) represented by $CH_2=CH(R^{21})C(O)OC(R^{22})(R^{23})OR^{24}$.

The monomer (m2) may, for example, be 1-ethoxyethyl(meth)acrylate, 1-methoxyethyl(meth)acrylate, 1-n-butoxyethyl(meth)acrylate, 1-isobutoxyethyl (meth)acrylate, 1-(2-chloroethoxy)ethyl(meth)acrylate, 1-(2-ethylhexyloxy)ethyl (meth)acrylate, 1-n-propoxyethyl(meth)acrylate, 1-cyclohexyloxyethyl(meth)acrylate, 1-(2-cyclohexylethoxy)ethyl(meth)acrylate or 1-benzyloxyethyl(meth)acrylate. As the monomer (m2), one type may be used alone, or two or more types may be used in combination.

The monomer (m2) may, for example, be produced by reacting a (meth)acrylic acid with a vinyl ether in the presence of an acid catalyst, as shown in the following formula. Here, the following formula is an example of the formula (II) wherein $R^{22}$ is a methyl group.

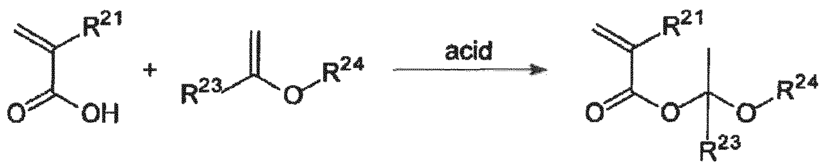


(Unit (u3))

The unit (u3) is a unit (excluding the same unit as the unit (u2)) having a cyclic ether. The unit (u3) preferably has a cyclic ether in its side chain.

In a case where the polymer (A) has the unit (u3), that is in a case where the polymer (A) is a polymer (A'), by heat treatment of a liquid repellent film formed from the polymer (A) after development, the cyclic ether in the unit (u3) and a carboxy group produced by heat decomposition of the acid-dissociable group in the unit (u2) are reacted to form a crosslinked structure, whereby a liquid repellent cured film being more excellent in liquid repellency is formed. The polymer (A') is a polymer having the unit (u1), the unit (u2) and the unit (u3).

The cyclic ether may, for example, be an epoxy group, an oxetane group or a 3,4-epoxycyclohexyl group. The cyclic ether is preferably an epoxy group or an oxetane group, particularly preferably an epoxy group, from the following reasons.

An epoxy group and an oxetane group are less reactive with a carboxy group at a relatively low temperature, but are easily reactive with a carboxy group at a relatively high temperature. That is, an epoxy group and an oxetane group are less reactive with a carboxy group produced by hydrolysis of the acid-dissociable group in the unit (u2) by an acid generated from a photo-acid generator upon exposure, but are easily reactive with a carboxy group produced by heat decomposition of the acid-dissociable group in the unit (u2) by heat treatment after development. Accordingly, the unit (u3) and the unit (u2) are less likely to form a crosslinked structure within a period of from the exposure to the development, and there is no influence on developability of the photosensitive film. On the other hand, a crosslinked structure is formed from the unit (u3) and the unit (u2) by heat treatment after the development, and a liquid repellent

cured film is thereby formed.

From the viewpoint of the above reason and availability of a monomer as a raw material, the unit (u3) is preferably a unit represented by the following formula (III):

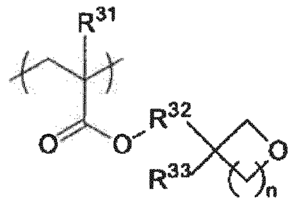

(III)

wherein $R^{31}$, $R^{32}$, $R^{33}$ and n are as defined above.

Among them, $R^{31}$ is preferably a hydrogen atom or a methyl group. $R^{32}$ is preferably a $C_{1-6}$ alkylene group, and from the viewpoint of availability of a monomer as a raw material, it is particularly preferably $-CH_2-$. $R^{33}$ is preferably a hydrogen atom or a $C_{1-6}$ alkyl group, and from the viewpoint of availability of a monomer as a raw material, a hydrogen atom is particularly preferred when n is 0, and an ethyl group is particularly preferred when n is 1.

The unit represented by the formula (III) is a unit derived from the monomer (m3) represented by the following formula:

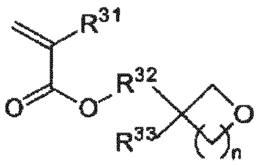

The monomer (m3) may, for example, be glycidyl(meth)acrylate, (3-ethyloxetan-3-yl)methyl(meth)acrylate, 4-hydroxybutyl(meth)acrylate glycidyl ether or 3,4-epoxycyclohexylmethyl(meth)acrylate. As the monomer (m3), one type may be used alone, or two or more types may be used in combination.

(Unit (u4))

The unit (u4) is a unit other than the unit (u1), the unit (u2) and the unit (u3). The unit (u4) may be a unit derived from a monomer (m4) other than the monomer (m1) to the monomer (m3).

The monomer (m4) may, for example, be methyl(meth)acrylate, ethyl (meth)acrylate, propyl(meth)acrylate, n-butyl(meth)acrylate, isobutyl(meth)acrylate, tert-butyl(meth)acrylate, hexyl(meth)acrylate, cyclohexyl(meth)acrylate, 2-ethylhexyl (meth)acrylate, octyl(meth)acrylate, decyl(meth)acrylate, isodecyl(meth)acrylate, lauryl(meth)acrylate, stearyl(meth)acrylate, benzyl(meth)acrylate, isobornyl (meth)acrylate, adamantyl(meth)acrylate or dimethylaminoethyl(meth)acrylate. As the monomer (m4), one type may be used alone, or two or more types may be used in combination.

[Polymer (B)]

The polymer (B) is a polymer other than the polymer (A), having the unit (u1). Among them, when the polymer (B) has the unit (u3), that is when the polymer (B) has the unit (u1) and the unit (u3), the polymer (B) is especially referred to as the polymer (B'), provided that the polymer (B') is a polymer other than the polymer (A) and the polymer (A'). The polymer (B) and the polymer (B') may have the unit (u4).

[Polymer (C)]

The polymer (C) is a polymer other than the polymer (A), having the unit (u2). Among the, when the polymer (C) has the unit (u3), that is when the polymer (C) has the unit (u2) and the unit (u3), the polymer (C) is especially referred to as the polymer (C'), provided that the polymer (C') is a polymer other than the polymer (A) and the polymer (A'). The polymer (C) and the polymer (C') may also have the unit (u4).

[Polymer (D)]

The polymer (D) is a polymer having the unit (u3), other than the polymer (A'), the polymer (B') and the polymer

(C'). The polymer (D) may also have the unit (u4).

In a case where the photosensitive resin composition has the unit (u3), as the polymer, there may be e.g. a case where the polymer (A') is used, a case where the polymer (B') and the polymer (C') are used, a case where the polymer (B') and the polymer (C) are used, a case where the polymer (B) and the polymer (C') are used, or a case where the polymer (B), the polymer (C) and the polymer (D) are used.

(Proportion of each unit)

The proportion of the unit (u1) is preferably from 3 to 50 mol%, more preferably from 3 to 28 mol%, particularly preferably from 3 to 25 mol%, to the total number of units constituting the composition. Here, "the total number of units constituting the composition" means a total number of all units in the polymer (the polymer (A), the polymer (B), the polymer (C) (when used), and the polymer (D) (when used)) contained in the photosensitive resin composition.

Especially the proportion of the unit (u1) in all units in the polymer (A) is preferably from 3 to 50 mol%, more preferably from 3 to 28 mol%, particularly preferably from 3 to 25 mol%. When the proportion is at least the lower limit of the above range, it is possible to impart the liquid repellency to the liquid repellent film. When the proportion is at most the upper limit of the above range, it is possible to suppress development failure of the photosensitive film, and the resolution of a pattern further increases.

The proportion of the unit (u2) is from 35 to 97 mol%, preferably from 35 to 95 mol%, particularly preferably from 35 to 90 mol%, to the total number of units constituting the composition.

Especially the proportion of the unit (u2) in all units in the polymer (A) is from 35 to 97 mol%, preferably from 35 to 95 mol%, particularly preferably from 35 to 90 mol%. Further, in a case where the polymer (A) has a unit other than the unit (u1) and the unit (u2), the proportion of the unit (u2) is most preferably from 35 to 75 mol%. When the proportion is at least the lower limit of the above range, it is possible to suppress development failure of the photosensitive film, and the resolution of a pattern further increases. When the proportion is at most the upper limit of the above range, effects obtained by other units are less likely to be impaired.

The total of the above proportion of the unit (u1) and the above proportion of the unit (u2) may not be 100 mol% in some cases, but in such a case, the rest is a unit other than the unit (u1) and the unit (u2).

When the photosensitive resin composition has the unit (u3), the proportion of the unit (u3) is preferably from 1 to 60 mol%, more preferably from 1 to 50 mol%, to the total number of units constituting the composition. Especially the proportion of the unit (u3) in the polymer (A') is preferably from 1 to 60 mol%, more preferably from 1 to 50 mol%, to the total units of the polymer (A). When the proportion is at least the lower limit of the above range, the strength of the liquid repellent cured film increases. When the proportion is at most the upper limit of the above range, effects obtained by other units are less likely to be impaired.

When the photosensitive resin composition has the unit (u4), the proportion of the unit (u4) is preferably from 1 to 60 mol%, more preferably from 1 to 50 mol%, to the total number of units constituting the composition. Especially in a case where the polymer (A) contains the unit (u4), the proportion is preferably from 1 to 60 mol%, more preferably from 1 to 50 mol%, to the total units of the polymer. When the proportion is at most the upper limit of the above range, effects obtained by other units are less likely to be impaired.

The proportion of each unit in the polymer (A) can be obtained, for example, from the integration ratio of the peaks specific to each unit in $^1$H-NMR.

(Mass average molecular weight, acid value)

The mass average molecular weight of each of the polymer (A), the polymer (B), the polymer (C) and the polymer (D), is preferably from 5,000 to 200,000, more preferably from 5,000 to 100,000, particularly preferably from 7,000 to 70,000. When the mass average molecular weight is within the above range, it is possible to stably form a liquid repellent film by photolithography. Further, in a case where the surface of a substrate is coated with a photosensitive resin composition by a spin coating method or a bar coating method to form a wet-state photosensitive film having a film thickness of from about 3 to about 10 μm, the mass average molecular weight is preferably at least 20,000 with a view to obtaining a good photosensitive film free from cissing.

The acid value of each of the polymer (A) and the polymer (C) is preferably from 80 to 250 mgKOH/g. When the acid value is within the above range, it is possible to stably form a liquid repellent film by photolithography.

(Process for producing polymer)

The polymer (A), the polymer (B), the polymer (C) and the polymer (D) can be produced by a known polymerization such as solution polymerization, bulk polymerization or emulsion polymerization. Among them, solution polymerization is preferred.

In the polymerization, a chain transfer agent may be used. By using the chain transfer agent, it is possible to adjust a mass average molecular weight of the polymers. The chain transfer agent may, for example, be a thiol type chain transfer agent represented by the following formula (S1):

$$HS\text{-}CR^1R^2R^3 \qquad (S1)$$

wherein $R^1$ and $R^2$ are each independently a hydrogen atom or an alkyl group in which one or more of hydrogen atoms may be substituted, $R^3$ is an alkyl group in which one or more of hydrogen atoms may be substituted, a cycloalkyl group in which one or more of hydrogen atoms may be substituted, an aryl group in which one or more of hydrogen atoms may be substituted, or a heteroaryl group in which one or more of hydrogen atoms may be substituted, and two or three of $R^1$ to $R^3$ may be linked with one another to form a ring structure.

In a case where one or more of hydrogen atoms in the alkyl group of $R^1$ to $R^3$ are substituted, the substituent may, for example, be a hydroxy group. In a case where one or more of hydrogen atoms in the cycloalkyl group, the aryl group or the heteroaryl group in $R^3$ are substituted, the substituent may, for example, be a $C_{1-6}$ alkyl group, a $C_{1-6}$ alkoxy group or a halogen atom.

Each of $R^1$ and $R^2$ is preferably a hydrogen atom or a linear or branched $C_{1-20}$ alkyl group, particularly preferably a hydrogen atom or a methyl group.

$R^3$ is preferably a linear or branched $C_{1-20}$ alkyl group, a $C_{3-6}$ cycloalkyl group, a $C_{6-10}$ aryl group or a $C_{4-6}$ heteroaryl group (such as a furyl group or a pyridyl group), in which one or more of hydrogen atoms may be substituted.

In a case where two or three of $R^1$ to $R^3$ are linked with another to form a ring structure, the ring structure may be an alicyclic structure or an aromatic ring structure. Further, the cyclic structure may be a monocyclic type or a polycyclic type. As an example of a cyclic structure formed by bonding of two among $R^1$ to $R^3$, a $C_{3-6}$ cycloalkane structure may be mentioned.

The above thiol type chain transfer agent is preferably a compound other than compounds in which $R^1$ and $R^2$ are respectively hydrogen atoms and further $R^3$ is a linear alkyl group having no hydrogen atoms substituted (that is, a compound in which-$CR^1R^2R^3$ is a linear alkyl group) with a view to obtaining a uniform liquid repellent film.

As a specific example of the above thiol type chain transfer agent, dodecanethiol, octadecanethiol, thioglycerol, 2-ethylhexanethiol, cyclohexyl mercaptan, furfuryl mercaptan or benzylthiol may, for example, be mentioned. With a view to obtaining a uniform liquid repellent film, thioglycerol, 2-ethylhexanethiol, cyclohexyl mercaptan, furfuryl mercaptan or benzylthio is preferred, and from the viewpoint of low odor property, thioglycerol is particularly preferred.

In a case where the chain transfer agent is used in polymerization, either one or both of main chain terminals of the resulting polymer has a group derived from the chain transfer agent. For example, in a case where the above thiol type chain transfer agent is used, either one or both of main chain terminals of the resulting polymer has a group represented by the following formula (IV):

$$\text{-}S\text{-}CR^1R^2R^3 \qquad (IV)$$

wherein $R^1$ to $R^3$ are as defined above.

The photosensitive resin composition as explained above has the unit (u1), and therefore a liquid repellent film formed therefrom can exhibit liquid repellency. Further, the photosensitive resin composition has the unit (u2), and therefore a photosensitive film formed therefrom can be developed with an aqueous alkaline solution without performing PEB treatment. Further, since no PEB treatment is thus needed, it is possible to suppress diffusion of an acid, and it is thereby possible to form a liquid repellent film having a predetermined pattern at a high resolution.

A composition after exposure of the photosensitive resin composition may be a resin composition having a unit represented by the following formula (I), a unit represented by the following formula (IIa) and a unit represented by the following formula (III):

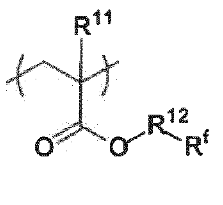
(I)

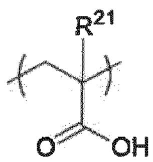
(IIa)

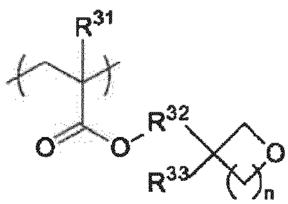
(III)

wherein $R^{11}$, $R^{12}$, $R^f$, $R^{21}$, $R^{31}$, $R^{32}$, $R^{33}$ and n are as defined above.

As a resin composition having the unit (IIa), a composition formed on an exposed portion at the time of exposing

a photosensitive film containing the polymer (A) having the unit represented by the formula (I), the unit represented by the formula (II) and the unit represented by the formula (III).

[Photosensitive resin composition]

The photosensitive resin composition of the present invention preferably contains a photo-acid generator. The photosensitive resin composition of the present invention may contain other components such as a solvent.

The photo-acid generator may be any compound as long as it generates an acid by irradiation with light. The photo-acid generator may, for example, be a known photo-acid generator.

In an application in which light as a noise is not suitable (such as a biochip), the photo-acid generator is preferably a photo-acid generator having an absorption coefficient at a wavelength of 365 nm of preferably at most 400 $mL\cdot g^{-1}\cdot cm^{-1}$, particularly preferably at most 200 $mL\cdot g^{-1}\cdot cm^{-1}$. When the absorption coefficient is at most the upper limit of the above range, for example in a biochip, it is possible to suppress light as a noise generated from a water repellent film of the biochip when beads accommodated in the biochip are subjected to fluorescence analysis. The light as a noise is light observed as fluorescence when measured by a laser light excitation type fluorescence analyzer. The cause of such light generation is not clear, but stray light due to autofluorescence or scattering is considered.

Further, in an application in which light as a noise is not suitable (such as a biochip), the photo-acid generator is preferably a photo-acid generator having an absorption coefficient at a wavelength of 365 nm of preferably at least 1 $mL\cdot g^{-1}\cdot cm^{-1}$, particularly preferably at least 10 $mL\cdot g^{-1}\cdot cm^{-1}$.

As the photo-acid generator, a triarylsulfonium salt, a diaryliodonium salt or a sulfonyl diazomethane may, for example, be mentioned.

As a specific example of the cationic moiety of the polyarylsulfonium salt or the diaryliodonium salt, triphenylsulfonium, diphenyl-4-methylphenylsulfonium, tris(4-methylphenyl)sulfonium, diphenyl-2,4,6-trimethylphenylsulfonium, 4-(phenylthio)phenyldiphenylsulfonium, diphenyliodonium, 4-isopropyl-4'-methyldiphenyliodonium, 4-methyl-4'-methylpropyldiphenyliodonium, bis(4-tert-butylphenyl)iodonium or 4-methoxyphenylphenyliodonium may, for example, be mentioned.

As a specific example of the anionic moiety of the triarylsulfonium salt or the diaryliodonium salt, trifluoromethanesulfonate, nonafluorobutanesulfonate, hexafluorophosphate, tetrafluoroborate, tris(pentafluoroethyl)trifluorophosphate, tris(heptafluoropropyl)trifluorophosphate, tris(nonafluoroisobutyl)trifluorophosphate or bis(nonafluoroisobutyl)tetrafluorophosphate may, for example be mentioned.

As a specific example of sulfonyldiazomethane, bis(phenylsulfonyl)diazomethane, bis(tert-butylsulfonyl)diazomethane, bis(cyclohexylsulfonyl)diazomethane or bis(p-toluenesulfonyl)diazomethane may, for example, be mentioned.

From the viewpoint of low fluorescence generated from the water repellent film and excellent photocuring performance, the photo-acid generator is preferably 4-(phenylthio)phenyldiphenylsulfonium tris(heptafluoropropyl)trifluorophosphate, 4-(phenylthio)phenyldiphenylsulfonium tris(nonafluoroisobutyl)trifluorophosphate, 4-(phenylthio)phenyldiphenylsulfonium bis(nonafluoroisobutyl)tetrafluorophosphate, 4-(phenylthio)phenyldiphenylsulfonium (pentafluoroethyl)trifluorophosphate, diphenyl-2,4,6-trimethylphenylsulfonium trifluoromethanesulfonate, diphenyl-2,4,6-trimethylphenylsulfonium nonafluorobutanesulfonate, bis(phenylsulfonyl)diazomethane or bis(p-toluenesulfonyl)diazomethane.

The photo-acid generator to be used may be a commercial product such as IRGACURE (tradename) 250 manufactured by BASF; CPI (tradename)-100P or CPI (tradename)-210S manufactured by San-Apro Ltd.; or WPAG199 manufactured by Wako Pure Chemical Industries, Ltd. As the photo-acid generator, one type may be used alone, or two or more types may be used in combination.

(Solvent)

The solvent may be any one as long as it can dissolve or disperse the polymer and the photo-acid generator, and the solvent is preferably one which can dissolve them.

The solvent may, for example, be a fluorinated compound such as 1H-tridecafluorohexane (ASAHIKLIN (tradename) AC2000, manufactured by Asahi Glass Company, Limited), 1,1,1,2,2,3,3,4,4,5,5,6,6-tridecafluorooctane (ASAHIKLIN (tradename) AC6000, manufactured by Asahi Glass Company, Limited), 1,1,2,2-tetrafluoro-1-(2,2,2-trifluoroethoxy)ethane (ASAHIKLIN (tradename) AE3000, manufactured by Asahi Glass Company, Limited), dichloropentafluoropropane (ASAHIKLIN (tradename) AK-225, manufactured by Asahi Glass Company, Limited), 1,1,1,2,3,4,4,5,5,5-decafluoro-3-methoxy-2-(trifluoromethyl)pentane (CYTOP (tradename) CT-solv100E, manufactured by Asahi Glass Company, Limited), 1-methoxynonafluorobutane (Novec (tradename) 7100, manufactured by 3M Japan Limited), 1-ethoxynonafluorobutane (Novec (tradename) 7200, manufactured by 3M Japan Limited), 1,1,1,2,3,3-hexafluoro-4-(1,1,2,3,3,3-hexafluoropropoxy)pentane (Novec (tradename) 7600, manufactured by 3M Japan Limited), 2H,3H-perfluoropentane (Vertrel (tradename) XF, manufactured by Du Pont-Mitsui Fluorochemicals Company, Ltd.),

3,3,4,4,5,5,6,6,7,7,8,8,8-tridecafluoro-1-octanol, 4,4,5,5,6,6,7,7,8,8,9,9,9-tridecafluoro-1 -nonanol, hexafluorobenzene, hexafluoro-2-propanol, 2,2,3,3,4,4,5,5-octafluoro-1-pentanol or 1H,1H,7H-dodecafluoro-1-heptanol; a non-fluorinated ketone such as cyclopentanone, cyclohexanone, methyl amyl ketone or 2-butanone; an ester such as ethyl lactate, methyl benzoate, ethyl benzoate, benzyl benzoate, methyl cellsolve acetate, ethyl cellsolve acetate, propylene glycol methyl ethyl acetate, propylene glycol monomethyl ether acetate, propylene glycol monoethyl ether acetate or propylene carbonate; or an ether such as ethylene glycol methyl ethyl ether, tetrahydrofuran, dioxane, dimethoxyethane, diethoxyethane, anisole, diglyme or triglyme.

From the viewpoint of high solubility, high boiling point and excellent film-forming property, the solvent is preferably propylene glycol monomethyl ether acetate, propylene glycol monoethyl ether acetate, diethylene glycol methyl ethyl ether, hexafluoro-2-propanol, 2,2,3,3,4,4,5,5-octafluoro-1-pentanol or 1H,1H,7H-dodecafluoro-1-heptanol. As the solvent, one type may be used alone, or two or more of them may be used in combination.

(Other components)

As such other components, a polymer other than the above-mentioned polymers, a photosensitizer, an antioxidant, a thermal polymerization initiator, a thermal polymerization inhibitor, an adhesion promoter, a leveling agent, a defoaming agent, a precipitation prevention agent, a dispersant, a plasticizer, a thickener or other additives may, for example, be mentioned.

As the adhesion promoter, a coupling agent such as a silane coupling agent may be used. A preferred silane coupling agent may, for example, be 3-glycidoxypropyltrialkoxysilane, 3-glycidoxypropylalkyldialkoxysilane, 3-methacryloxypropyltrialkoxysilane, 3-methacryloxypropylalkyldialkoxysilane, 3-chloropropyltrialkoxysilane, 3-mercaptopropyltrialkoxysilane, 3-aminopropyltrialkoxysilane, 3-aminopropylalkyldialkoxysilane, heptadecafluorooctyltrimethoxysilane, β-(3,4-epoxycyclohexyl)ethyltrialkoxysilane, vinyltrichlorosilane or vinyltrilakoxysilane.

Among them, 3-glycidoxypropytrialkoxysilane or 3-methacryloxypropyltrialkoxysilane is more preferred, 3-glycidoxypropyltrialkoxysilane is further preferred.

(Proportion of each component)

The total proportion of the polymer (A), the polymer (B), the polymer (C) and the polymer (D) is preferably from 5 to 50 mass%, particularly preferably from 10 to 40 mass% in the photosensitive resin composition.

The proportion of the photo-acid generator is preferably from 0.1 to 10 mass%, particularly preferably from 1 to 5 mass%, in the photosensitive resin composition. The proportion of the solvent is preferably from 40 to 94.9 mass%, particularly preferably from 45 to 89 mass% in the photosensitive resin composition. The proportion of other components is preferably from 0 to 20 mass%, particularly preferably from 0 to 10 mass% in the photosensitive resin composition.

[Method for forming liquid repellent film]

The method for forming a liquid repellent film of the present invention has the following steps:

Step (a): a step of coating the surface of a substrate with the photosensitive resin composition of the present invention to form a photosensitive film.

Step (b): a step of exposing the photosensitive film to form a latent image having a predetermined pattern.

Step (c): a step of developing the photosensitive film having the latent image formed, with an aqueous alkaline solution, to form a liquid repellent film having a predetermined pattern.

Step (d): a step of exposing the liquid repellent film to hydrolyze an acid-dissociable group of the unit (u2) in the polymer (A), as the case requires.

Step (e): a step of applying heat treatment to the liquid repellent film to form a crosslinked structure, thereby to form a liquid repellent cured film, as the case requires.

(Step (a))

As shown in Fig. 1, the photosensitive resin composition of the present invention is applied on the surface of a substrate 10 to form a wet-state photosensitive film (not shown), and dried (hereinafter, referred to also as prebaked) as the case requires, to form a dry-state photosensitive film 12.

The substrate may, for example, be various glass plates, a thermoplastic sheet, a silicon wafer; a metal substrate such as a stainless steel (SUS) or aluminum; or a resin substrate having a metal foil such as a copper foil adhered to the surface thereof. As a material of the thermoplastic sheet, polypropylene, polyethylene, polycarbonate, polymethyl methacrylate or polystyrene may, for example, be mentioned. As a coating method, a spray method, a roll coating

method, a spin coating method or a bar coating method may, for example, be mentioned.

By prebaking the wet-state photosensitive film, a solvent volatilizes, and a dry-state photosensitive film with no fluidity is obtainable. The pre-baking conditions vary depending on the type of each component, a blending ratio, etc., but are preferably at a temperature of from 50 to 120°C for from 10 to 2,000 seconds.

The thickness of the dry-state photosensitive film is not particularly limited, but is preferably from 0.1 to 20 μm, particularly preferably from 0.5 to 10 μm.

(Step (b))

After the step (a), as shown in Fig. 1, the photosensitive film 12 is irradiated with light from a light source 22 through a mask 20 having a predetermined pattern to form an exposed portion 14, whereby a latent image 16 having a predetermined pattern is obtained. In the exposed portion 14, the acid-dissociable group of the unit (u2) in the photosensitive resin composition is hydrolyzed by an acid from the photo-acid generator to produce a carboxy group.

The light is preferably light beam having a wavelength of from 100 to 500 nm, more preferably light beam having a wavelength of from 200 to 450 nm, particularly preferably i-line (365 nm).

The light source is preferably e.g. a high-pressure mercury lamp, (UV) LED, laser or the like. The exposure dose is preferably within a range of from 5 to 10,000 mJ/$cm^2$.

In the method for forming a liquid repellent film described in Patent Document 4, it is necessary to perform PEB treatment after exposing and before developing a photosensitive film. On the other hand, in the method for forming a liquid repellent film of the present invention, it is not necessary to perform PEB treatment since the photosensitive resin composition has the unit (u2). Nevertheless, in the present invention, it is not denied to carry out PEB treatment, and the photosensitive film 12 may be subjected to PEB treatment after the step (b) and before the step (c), for the purpose of promoting hydrolysis of the acid-dissociable group of the unit (u2) in the photosensitive resin composition contained in the exposed portion 14 of the photosensitive film 12.

Further, the PEB treatment in the method for forming a liquid repellent film described in Patent Document 4 was needed to be performed at a relatively high temperature (paragraph [0051] of Patent Document 4). On the other hand, in the present invention, even when the PEB treatment is performed, it is possible to perform the PEB treatment at a relatively low temperature since the photosensitive resin composition has the unit (u2). In a case where the photosensitive resin composition has the unit (u3), if the temperature of the PEB treatment becomes too high, carboxy groups produced by hydrolysis of the acid-dissociable group of the unit (u2) is reacted with the cyclic ether of the unit (u3) to form a crosslinked structure, and therefore it is difficult to carry out development in the subsequent step (c).

When the photosensitive resin composition has no unit (u3), the temperature of the PEB treatment is preferably from 50 to 150°C.

When the photosensitive resin composition has the unit (u3), the temperature of the PEB treatment is preferably from 50 to 130°C, more preferably from 50 to 110°C, particularly preferably from 50 to 80°C.

(Step (c))

After the step (b), as shown in Fig. 1, the photosensitive film 12 having the latent image 16 formed is developed with an aqueous alkaline solution to remove the exposed portion 14, whereby a liquid repellent film 18 having a predetermined pattern is formed.

As an alkali of the aqueous alkaline solution, an alkali metal hydroxide such as lithium hydroxide, sodium hydroxide or potassium hydroxide; an alkali metal carbonate such as sodium carbonate or potassium carbonate; an alkali metal bicarbonate such as sodium bicarbonate or potassium bicarbonate; an ammonium hydroxide such as tetramethylammonium hydroxide, tetraethylammonium hydroxide or choline hydroxide; sodium silica or sodium metasilicate may, for example, be mentioned.

The aqueous alkaline solution may contain e.g. a water-soluble organic solvent (such as methanol or ethanol) or a surfactant. The surfactant may be a nonionic surfactant.

From the viewpoint of improving wettability to the photosensitive film 12, the aqueous alkaline solution has a surface tension of preferably at most 60 mN/m, more preferably at most 50 mN/m.

From the viewpoint of improving wettability to the photosensitive film 12, the aqueous alkaline solution is particularly preferably an aqueous alkaline solution containing a surfactant and further having a surface tension of at most 50 mN/m.

The pH of the aqueous alkaline solution is preferably from 10 to 14.

The developing time is preferably from 30 to 180 seconds.

As the developing method, a paddle method, a dipping method or a shower method may, for example, be mentioned. After the development, the liquid repellent film is preferably subjected to washing with water (rinsing). The rinsing time is preferably from 30 to 90 seconds. After the rinsing, it is preferred to carry out drying the liquid repellent film.

(Step (d))

After the step (c), the liquid repellent film may be exposed so as to hydrolyze the acid-dissociable group of the unit (u2), as the case requires.

(Step (e))

In order to promote crosslinking of the liquid repellent film, the liquid repellent film may be subjected to heat treatment (curing).

In a case where the photosensitive resin composition has the unit (u3), by the heat treatment of the liquid repellent film, the cyclic ether of the unit (u3) and the carboxy group produced by the hydrolysis of the acid-dissociable group in the unit (u2) are reacted to form a crosslinked structure, whereby a liquid repellent cured film is formed.

The heat treatment are preferably carried out under conditions at from 120 to 150°C for from 5 to 90 minutes. As a heating device, a hot plate or an oven may, for example, be mentioned.

[Process for producing biochip]

The biochip of the present invention has a lyophilic substrate and a liquid repellent film being provided on the surface of the lyophilic substrate and having a plurality of pores (receptacles) or grooves penetrating in the thickness direction.

A biochip is a device capable of massively and concurrently detecting a biomolecule such as DNA, protein or sugar, or a target compound. As a highly sensitive detection method, e.g. beads labelled with another antibody interacting specifically with target molecules are used so that the target molecules interact with the beads, and then the beads are encapsulated in a microarray in the biochip, followed by detecting. Fluorescence analysis is often used for the detection.

The biochip can be produced in the same manner as in the above-mentioned method for forming a liquid repellent film, by using a lyophilic substrate as a substrate and using, as a mask, one having a pattern corresponding to pores (receptacles) or grooves.

The lyophilic substrate may, for example, be the above-mentioned various glass substrates or a thermoplastic sheet. The lyophilic substrate is preferably one having a low fluorescence intensity. From the viewpoint of heat resistance, the lyophilic substrate is preferably a glass plate, particularly preferably a quartz glass plate.

The lyophilic substrate is preferably one having a contact angle of water of less than 90°, or one having a contact angle of propylene glycol monomethyl ether acetate of less than 10°.

The liquid repellent film is preferably one having a contact angle of water of at least 90°, or one having a contact angle of propylene glycol monomethyl ether acetate of at least 10°. The thickness of the liquid repellent film is not limited, but is preferably from 0.01 to 100 μm, more preferably from 0.1 to 50 μm. The shape of the pores or the grooves formed in the liquid repellent film is not particularly limited.

There are no restrictions on the size of the pores, but for example in the case of a circular shape in a plan view, the diameter is preferably from 1 to 1,000 μm, more preferably from 5 to 500 μm. The distance between the pores is not limited, but the distance between the adjacent pores is preferably from 1 to 1,000 μm, more preferably from 5 to 500 μm.

There are no restrictions on the width of the grooves, but it is preferably from 1 to 2,000 μm, more preferably from 5 to 1,000 μm. There are no restrictions on the interval between the grooves, but it is preferably from 1 to 2,000 μm, more preferably from 5 to 1,000 μm.

EXAMPLES

Now, the present invention will be described in detail with reference to Examples, but the present invention is not limited thereto. Here, Ex. 1 to 18 and Ex. 25 to 36 are Examples of the present invention, and Ex. 19 to 24 and Ex. 37 are Comparative Examples.

[Physical properties and evaluations]

($^1$H-NMR)

$^1$H-NMR spectra of a monomer and a polymer were measured by using a FT-NMR apparatus (JNM-AL300, manufactured by JEOL Ltd.).

(Mass average molecular weight)

The mass average molecular weight (Mw) was determined by employing a calibration curve prepared by using a standard polymethyl methacrylate sample with a known molecular weight, from the chromatogram obtained by a high-speed gel permeation chromatography (GPC) apparatus (HLC-8220, manufactured by TOSOH CORPORATION).

(Acid value)

The proportion of each unit in the polymer was determined by $^1$H-NMR, and the acid value was obtained from the following formula:

Acid value = (molecular weight of potassium hydroxide × mass average molecular weight of unit (u2) × mol% of unit (u2)) × 1,000 / (mass average molecular weight of unit (u1) × mol% of unit (u1) + mass average molecular weight of unit (u2) × mol% of unit (u2) + mass average molecular weight of unit (u3) × mol% of unit (u3) + mass average molecular weight of unit (u4) × mol% of unit (u4))

(Contact angle of water or PGMEA)

The surface of a quartz glass substrate (25 mm × 50 mm) was spin coated with a photosensitive resin composition at 1,000 rpm for 30 seconds, and heated at 100°C for 120 seconds using a hot plate, then heated at 150°C for 30 minutes to form a 3 μm-thick photosensitive film in a dry state. The contact angle of about 2 μL of distilled water or PGMEA placed on the surface of the photosensitive film was measured by a contact angle measuring apparatus (DM-701, manufactured by Kyowa Interface Science Co., Ltd.).

(Resolution)

The surface of a 6-inch silicon wafer (manufactured by MITSUBISHI MATERIALS TRADING CORPORATION) was spin coated with a photosensitive resin composition at 1,000 rpm for 30 seconds, and heated at 100°C for 120 seconds using a hot plate to form a 2 μm-thick photosensitive film in a dry state. The photosensitive film was exposed using a high-pressure mercury lamp as a light source through a photomask (a mask capable of forming a circular hole pattern with a diameter changed by 1 μm from 2 μm to 10 μm) so that the exposure dose of i-line would be 10,000 mJ/cm$^2$ in Ex. 12 and 500 mJ/cm$^2$ in Ex. 1 to 11 and 13 to 37.

The photosensitive film was developed for 60 seconds with a 2.38 mass% tetramethylammonium hydroxide aqueous solution (manufactured by TAMA CHEMICALS CO., LTD.), NMD-W (manufactured by TOKYO OHKA KOGYO CO., LTD.) or AD-10 (manufactured by TAMA CHEMICALS CO., LTD.) as a developer, followed by rinsing for 30 seconds with pure water, whereby a liquid repellent film having the hole pattern was formed. In order to remove the developer and the rinsing fluid, spin drying was carried out at 2,000 rpm for 30 seconds. The liquid repellent film was observed with a microscope (VHX DIGITAL MICROSCOPE, manufactured by KEYENCE CORPORATION), and the minimum hole pattern diameter of a hole opened was measured, and the resolution was evaluated based on the following standards.

○ (good): The minimum hole pattern diameter is at most 5 μm.
× (defective): The minimum hole pattern is at least 6 μm.

(Hole cross-sectional shape)

Regarding the liquid repellent film having the hole pattern, which was subjected to development in the same manner as in the resolution evaluation, the entire surface thereof was post-exposed so that the exposure dose of i-line would be 500 mJ/cm$^2$, and then post-baked at 150°C for 30 minutes. Regarding the liquid repellent film after the post-baking, the cross sectional shape of the hole was evaluated by a stylus film thickness meter (DEKTAK).

○ (good): Hole cross-sectional shape unchanged before and after post bake.
× (defective): Hole cross-sectional shape changed before and after post bake.

(Fluorescence intensity)

The surface of a quartz glass substrate (25 mm × 50 mm) was spin coated with a photosensitive resin composition at 1,000 rpm for 30 seconds, and heated at 100°C for 120 seconds using a hot plate to form a 2 μm-thick photosensitive film in a dry state. The photosensitive film was exposed using a high-pressure mercury lamp as a light source so that the exposure dose would be 500 $mJ/cm^2$. Then, the photosensitive film was post-baked at 150°C for 30 minutes using a hot plate.

The fluorescence intensity of the photosensitive film after the post-baking was measured by a microarray scanner (GenePix4000B, manufactured by Molecular Devices, LLC.) (excitation wavelength 532 nm, resolution 5 μm, laser output 100%, voltage of photomultiplier 1,000 V).

(Coating property)

The surface of a 6-inch silicon wafer (manufactured by MITSUBISHI MATERIALS TRADING CORPORATION) was spin coated with a photosensitive resin composition at 1,000 rpm for 30 seconds to form a photosensitive film in a wet state. Immediately after the spin coating, the photosensitive film formed was visually observed to confirm the presence of cissing. Further, the surface of the 6-inch silicon wafer was subjected to bar coating with a 200 μL photosensitive resin composition by using a No. 1 bar, thereby to form a photosensitive film in a wet state. Immediately after the bar coating, the photosensitive film formed was visually observed to confirm the presence of cissing.

○ (good): No cissing was observed in both cases of spin coating and bar coating.
× (defective): Cissing was observed on at least one of spin coating and bar coating.

[Monomer, polymerization solvent and polymerization initiator]

Monomer (m1) :

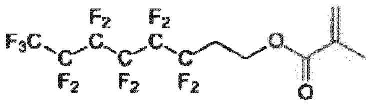

C6FMA

Monomer (m2) :

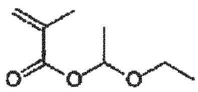

EEMA

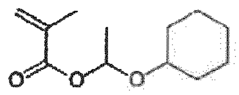

CHMA

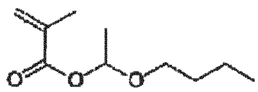

BEMA

Monomer (m3) :

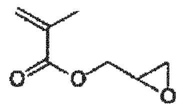

GMA

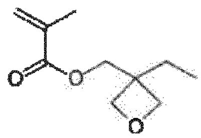

OXEMA

Monomer (m4) :

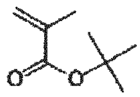

t-BuMA

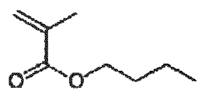

n-BuMA

(Monomer (m1))

C6FMA: 3,3,4,4,5,5,6,6,7,7,8,8,8-Tridecafluorooctyl methacrylate (C6FMA) was obtained by the method described in Ex. 1 of JP-A-2004-359616.

α-ClC6FA: α-Chloro-3,3,4,4,5,5,6,6,7,7,8,8,8-tridecafluorooctyl acrylate (α-ClC6FA) was obtained by the method described in Examples of JP-A-2010-24381.

(Monomer (m2))

EEMA:

55.8 g of ethyl vinyl ether (manufactured by Tokyo Chemical Industry Co., Ltd.) and 2.5 g of pyridinium p-toluenesulfonate (manufactured by ACROS) were mixed, and the mixture was subjected to nitrogen substitution for 30 minutes in an ice bath with stirring. 50.1 g of methacrylic acid (manufactured by Junsei Chemical Co., Ltd.) was added dropwise to the mixture, and the mixture was stirred overnight at room temperature. 0.8 g of sodium hydrogencarbonate (manufactured by Kanto Chemical Co., Inc.) and 1.4 g of sodium sulfate (manufactured by Kanto Kagaku Co., Inc.) were added to the reaction solution, then the solid content was filtered through a polytetrafluoroethylene (hereinafter referred to also as PTFE) having a diameter of 3 μm, and the filtrate was distilled off under reduced pressure. The remaining liquid was distilled under reduced pressure at 10 mmHg, and the liquid obtained at 40°C was collected to obtain 1-ethoxyethyl methacrylate (EEMA).

$^1$H-NMR (300.4 MHz, solvent: d-acetone, standard: tetramethylsilane (TMS)) of EEMA, δ (ppm): 1.1 (t, 3 H), 1.4 (d, 3 H), 1.9 (s, 3 H), 3.5 to 3.7 (m, 2 H), 5.6 (s, 1 H), 5.9 (q, 1 H), 6.1 (s, 1 H).

CHMA:

22.4 g of cyclohexyl vinyl ether (manufactured by Tokyo Chemical Industry Co., Ltd.) and 0.6 g of pyridinium p-toluenesulfonate (manufactured by ACROS) were mixed, and the mixture was subjected to nitrogen substitution for 30 minutes in an ice bath with stirring. 23.0 g of methacrylic acid (manufactured by Junsei Chemical Co., Ltd.) was added dropwise to the mixture, and the mixture was stirred overnight at room temperature. A saturated aqueous sodium hydrogen carbonate solution and ethyl acetate were added to the reaction solution, and the ethyl acetate layer was collected. Saturated brine was added to the collected liquid, and the ethyl acetate layer was collected and evaporated under reduced pressure. The remaining liquid was dried under reduced pressure at 40°C under 10 mmHg to obtain 1-cyclohexyloxyethyl methacrylate (CHMA).

$^1$H-NMR (300.4 MHz, solvent: d-acetone, standard: TMS) of CHMA, δ (ppm): 1.2 to 1.9 (m, 13 H), 3.6 (m, 1 H), 5.6 (s, 1 H), 6.1 (s, 2 H).

BEMA:

19.6 g of n-butyl vinyl ether (manufactured by Tokyo Chemical Industry Co., Ltd.) and 0.7 g of pyridinium p-toluenesulfonate (manufactured by ACROS) were mixed, and the mixture was subjected to nitrogen substitution for 30 minutes in an ice bath with stirring. 23.0 g of methacrylic acid (manufactured by Junsei Chemical Co., Ltd.) was added dropwise to the mixture, and the mixture was stirred overnight at room temperature. A saturated aqueous sodium hydrogen carbonate solution and ethyl acetate were added to the reaction solution, and the ethyl acetate layer was collected. Saturated brine was added to the collected liquid, and the ethyl acetate layer was collected and evaporated under reduced pressure. The remaining liquid was distilled under reduced pressure under 10 mmHg, and the liquid obtained at 60°C was collected to obtain 1-n-butoxyethyl methacrylate (BEMA).

$^1$H-NMR (300.4 MHz, solvent: d-acetone, standard: TMS) of BEMA, δ (ppm): 1.1 (t, 3H), 1.4 (d, 3H), 1.9 (s, 3H), 3.5 to 3.7 (m, 2H), 5.6 (s, 1H), 5.9 (q, 1H), 6.1 (s, 1H).

(Monomer (m3))

GMA: Glycidyl methacrylate (manufactured by Tokyo Chemical Industry Co., Ltd.)
OXEMA: (3-Ethyloxetan-3-yl)methyl methacrylate (OXE-30, manufactured by Osaka Organic Chemical Industry Ltd.)

(Monomer (m4))

t-BuMA: Tert-butyl methacrylate (manufactured by Tokyo Chemical Industry Co., Ltd.)
n-BuMA: n-Butyl methacrylate (manufactured by Tokyo Chemical Industry Co., Ltd.).

(Polymerization solvent)

MEK: 2-Butanone.
PGMEA: Propylene glycol monomethyl ether acetate.

(Polymerization initiator)

V65: 2,2'-Azobis(2,4-dimethylvaleronitrile) (manufactured by Wako Pure Chemical Industries, Ltd.).

(Chain transfer agent)

Thioglycerol (manufactured by Tokyo Chemical Industry Co., Ltd.).

[Each Component of Curable Composition]

Polymer (A-1):

1.4 g of C6FMA, 0.47 g of GMA, 1.55 g of EEMA and 0.042 g of V65 were dissolved in 31 g of MEK, and the solution was subjected to nitrogen substitution, followed by shaking at 50°C for 24 hours. The reaction solution was added to 500 mL of hexane, and the resulting precipitated solid was filtered through a PTFE filter having a pore diameter of 3 μm to obtain a polymer (A-1). The proportion of each unit, the mass average molecular weight and the acid value of the polymer (A-1) are shown in Table 1.

$^1$H-NMR (300.4 MHz, solvent: d-acetone, standard: TMS) of polymer (A-1), δ (ppm): 1.4 to 1.9 (m, 14H), 2.7 (br, 0.9H), 2.8 ppm (br, 1.9H), 3.2 (br, 0.4 H), 3.6 (br, 1H), 3.8 (br, 1.4H), 4.3 (br, 1H), 5.7 (br, 1H).

The proportion of each unit was obtained from the integral ratios of 3.2 ppm, 4.3 ppm and 5.7 ppm.

Polymers (A-2) to (A-13) and Polymers (X-1) to (X-6):

Polymers (A-2) to (A-13), and polymers (X-1) to (X-6) for Comparative Examples, were prepared in the same manner as in the procedure for producing the polymer (A-1) except that the type and the amount to be charged of each monomer were changed. The proportion of each unit, the mass average molecular weight and the acid value of each polymer, are shown in Table 1. The results of $^1$H-NMR (300.4 MHz, solvent: d-acetone, standard: TMS) of each polymer, are shown below.

Polymer (A-2) δ (ppm): 1.4-1.9 (m, 14H), 2.7 (br, 1.3H), 2.8 ppm (br, 1.7H), 3.2 (br, 0.6H), 3.6 (br, 1H), 3.8 (br, 1.6H), 4.3 (br, 1.4H), 5.7 (br, 1H).

Polymer (A-3) δ (ppm): 1.4-1.9 (m, 14H), 2.7 (br, 1.4H), 2.8 ppm (br, 2.4H), 3.2 (br, 0.7H), 3.6 (br, 1H), 3.8 (br, 1.6H), 4.3 (br, 1.4H), 5.7 (br, 1H).

Polymer (A-4) δ (ppm): 1.4-1.9 (m, 14H), 2.7 (br, 1H), 2.8 ppm (br, 1.6H), 3.2 (br, 0.3H), 3.6 (br, 1H), 3.8 (br, 1.3H), 4.3 (br, 1H), 5.7 (br, 1H).

Polymer (A-5) δ (ppm): 1.4-1.9 (m, 12H), 2.7 (br, 0.6H), 2.8 ppm (br, 1.2H), 3.2 (br, 0.2H), 3.6 (br, 1H), 3.8 (br, 1.1H), 4.4 (br, 0.7H), 5.7 (br, 1H).

Polymer (A-6) δ (ppm): 1.0-1.9 (m, 12H), 2.7 (br, 0.8H), 2.8 ppm (br, 1.1H), 3.6 (br, 1H), 3.8 (br, 1H), 4.4 (br, 1H), 5.7 (br, 1H).

Polymer (A-7) δ (ppm): 1.0-1.9 (m, 18H), 2.7 (br, 0.7H), 2.8 ppm (br, 1.3H), 3.6 (br, 0.8H), 3.8 (br, 0.9H), 4.1 (br, 0.8H), 4.4 (br, 3H), 5.7 (br, 1H).

Polymer (A-8) δ (ppm): 1.0-1.9 (m, 19H), 2.1 (br, 1.2H), 2.7 (br, 0.6H), 2.8 (br, 1.6H), 3.1 (br, 0.7H), 3.2 (br, 0.2H), 3.6 (br, 1H), 3.8 (br, 2.1H), 4.4 (br, 0.6H), 5.7 (br, 1H).

Polymer (A-9) δ (ppm): 1.0-1.9 (m, 31H), 2.7 (br, 1.9H), 2.9 (br, 20H), 3.2 (br, 0.7H), 3.7-3.8 (br, 1.5H), 4.4 (br, 1.4H), 5.9 (br, 1H).

Polymer (A-10) δ (ppm): 1.0-1.9 (m, 22H), 2.7 (br, 1.7H), 2.9 (br, 16H), 3.3 (br, 0.5H), 3.6 (br, 1H), 3.8 (br, 1.5H), 4.4 (br, 1.4H), 5.7 (br, 1H).

Polymer (A-11) δ (ppm): 1.0-1.9 (m, 17H), 2.7 (br, 1.1H), 2.9 ppm (br, 8H), 3.3 (br, 1H), 3.6 (br, 1H), 3.8 (br, 2H), 4.4 (br, 1.3H), 5.7 (br, 1H).

Polymer (A-12) δ (ppm): 1.0-1.9 (m, 16H), 2.7 (br, 1.1H), 2.9 ppm (br, 7.7H), 3.3 (br, 1H), 3.6 (br, 1H), 3.8 (br, 2H), 4.4 (br, 1.2H), 5.7 (br, 1H).

Polymer (A-13) δ (ppm): 1.0-1.9 (m, 15H), 2.7 (br, 1.0H), 2.8 ppm (br, 2.1H), 3.3 (br, 0.9H), 3.6 (br, 1H), 3.8

(br, 1.9H), 4.4 (br, 1.2H), 5.7 (br, 1H).

Polymer (X-1) δ (ppm): 1.4-1.9 (m, 23H), 2.7 (br, 3.4H), 2.9 ppm (br, 6.2H), 3.2 (br, 0.8H), 3.6 (br, 0.9H), 3.8 (br, 1.8H), 4.3 (br, 3.6H), 5.7 (br, 1H).

Polymer (X-2) δ (ppm): 1.4-1.9 (m, 28H), 2.7 (br, 4H), 2.8 ppm (br, 5H), 3.2 (br, 2H), 3.6 (br, 1H), 3.8 (br, 3H), 4.4 (br, 4.3H), 5.7 (br, 1H).

Polymer (X-3) δ (ppm): 1.0-1.9 (m, 10H), 2.7 (br, 0.8H), 2.8 ppm (br, 1.2H), 3.2 (br, 0.3H), 3.8 (br, 0.3H), 4.4 (br, 1H).

Polymer (X-4) δ (ppm): 1.0-1.4 (m, 11H), 1.5 (br, 17H), 1.7 (br, 1.5H), 1.9 (br, 4H), 2.7 (br, 1.2H), 2.9 ppm (br, 6.7H), 4.0 (br, 1H), 4.4 (br, 1H).

Polymer (X-5) δ (ppm): 1.0-1.4 (m, 10H), 1.5 (br, 25H), 1.9 (br, 5H), 2.7 (br, 1.5H), 2.9 (br, 7.8H), 4.4 (br, 1H).

Polymer (X-6) δ (ppm): 1.0-1.9 (m, 16H), 2.7 (br, 1.2H), 2.9 ppm (br, 7.5H), 3.3 (br, 1.1H), 3.6 (br, 1H), 3.8 (br, 2.2H), 4.4 (br, 1.1H), 5.7 (br, 1H).

Polymer (A-14):

4.00 g of C6FMA, 1.97 g of GMA, 3.66 g of EEMA, 0.10 g of thioglycerol and 0.40 g of V65were dissolved in 22.4 g of PGMEA, and the solution was subjected to nitrogen substitution, followed by shaking at 50°C for 24 hours. Thereafter, the temperature was raised to 70°C, followed by shaking for 2 hours. The reaction solution was filtered through a nylon filter having a pore size of 0.45 μm to obtain a PGMEA solution of the polymer (A-14). The proportion of each unit, the mass average molecular weight and the acid value of the polymer (A-14), are shown in Table 1. The proportion of each unit was determined from integral ratios of 2.5 ppm, 3.2 ppm, 4.3 ppm and 5.7 ppm. As a sample for measurement of NMR, the PGMEA solution of the polymer was added to hexane in an amount of twenty times, and the resulting precipitated solid was filtered through a PTFE filter having a pore diameter of 3 μm and dried under reduced pressure.

$^1$H-NMR (300.4 MHz, solvent: d-acetone, standard: TMS) of the polymer (A-14), δ (ppm): 1.4-1.9 (m, 14H), 2.5 (br, 0.02H), 2.7 (br, 1.1H), 2.8 ppm (br, 1.9H), 3.2 (br, 0.5H), 3.6 (br, 1.0H), 3.8 (br, 1.7H), 4.3 (br, 1.4H), 5.7 (br, 1H).

Polymers (A-15) to (A-21), (X-7) and (X-8):

The polymers (A-15) to (A-21), (X-7) and (X-8) were prepared in the same manner as in the procedure for producing the polymer (A- 14) except that the type and the amount to be charged of each monomer were changed. The proportion of each unit, the mass average molecular weight and the acid value of the polymer, are shown in Table 1.

$^1$H-NMR of copolymer (A-15) (300.4 MHz, solvent: d-acetone, standard: TMS) δ (ppm): 1.0-1.9 (m, 16H), 2.7 (br, 1.9H), 2.8 ppm (br, 2.2H), 3.2 (br, 1.1H), 3.6 (br, 1.1H), 3.8 (br, 1.2H), 4.4 (br, 2H), 5.7 (br, 1H).

Copolymer (A-16) δ (ppm): 1.0-1.9 (m, 17H), 2.7 (br, 2.4H), 2.8 ppm (br, 3.0H), 3.2 (br, 0.6H), 3.6 (br, 1.1H), 3.8 (br, 1.5H), 4.3 (br, 2.6H), 5.7 (br, 1H).

Copolymer (A-17) δ (ppm): 1.0-1.9 (m, 17H), 2.7 (br, 2.2H), 2.8 ppm (br, 3.5H), 3.2 (br, 0.5H), 3.6 (br, 1.1H), 3.8 (br, 1.6H), 4.3 (br, 2.5H), 5.7 (br, 1H).

Copolymer (A-18) δ (ppm): 1.0-1.9 (m, 18H), 2.7 (br, 2.3H), 2.8 ppm (br, 3.4H), 3.3 (br, 1.4H), 3.6 (br, 1.2H), 3.8 (br, 2.5H), 4.4 (br, 2.0H), 5.7 (br, 1H).

Copolymer (A-19) δ (ppm): 1.0-1.9 (m, 17H), 2.7 (br, 2H), 2.8 ppm (br, 3H), 3.3 (br, 1.4H), 3.6 (br, 1.3H), 3.8 (br, 2.6H), 4.4 (br, 1.7H), 5.7 (br, 1H).

Copolymer (A-20) δ (ppm): 1.4-1.9 (m, 15H), 2.7 (br, 1.5H), 2.8 ppm (br, 1.9H), 3.2 (br, 0.7H), 3.6 (br, 0.8H), 3.8 (br, 1.6H), 4.3 (br, 2.2H), 5.7 (br, 1H).

Copolymer (A-21) δ (ppm): 1.1-1.9 (m, 17H), 2.7 (br, 0.8H), 2.8 ppm (br, 3.1H), 4.3 (br, 1H).

$^1$H-NMR of polymer (X-7) (300.4 MHz, solvent: d-acetone, standard: TMS) δ (ppm): 1.0-1.9 (m, 2.7H), 2.0 (br, 1.0H), 2.7 ppm (br, 0.9H), 2.9 ppm (br, 0.7H), 3.3 (br, 0.5H), 3.8 (br, 0.6H), 4.4 (br, 1.0H).

Copolymer (X-8) δ (ppm): 1.0-1.9 (m, 17H), 2.7 (br, 3.2H), 2.8 ppm (br, 4.8H), 3.2 (br, 1.0H), 3.6 (br, 1.1H), 3.8 (br, 1.9H), 4.3 (br, 3.6H), 5.7 (br, 1H).

[Table 1]

| Polymer | Type of monomer constituting each unit | | | | Proportion of each unit (mol%) | | | | Use of chain transfer agent | Mass average molecular weight | Acid value (mgKOH/g) |
|---|---|---|---|---|---|---|---|---|---|---|---|
| | (u1) | (u2) | (u3) | (u4) | (u1) | (u2) | (u3) | (u4) | | | |
| (A-1) | C6FMA | EEMA | GMA | - | 19 | 60 | 21 | - | Absent | 34,000 | 161 |
| (A-2) | C6FMA | EEMA | GMA | - | 19 | 49 | 32 | - | Absent | 16,000 | 135 |
| (A-3) | C6FMA | EEMA | GMA | - | 18 | 50 | 32 | - | Absent | 12,000 | 137 |
| (A-4) | C6FMA | EEMA | GMA | - | 20 | 60 | 20 | - | Absent | 42,000 | 160 |
| (A-5) | C6FMA | EEMA | GMA | - | 19 | 70 | 11 | - | Absent | 51,000 | 190 |
| (A-6) | C6FMA | EEMA | - | - | 18 | 82 | - | - | Absent | 12,000 | 221 |
| (A-7) | C6FMA | EEMA | - | n-BuMA | 19 | 60 | - | 21 | Absent | 14,000 | 162 |
| (A-8) | C6FMA | EEMA | OXEMA | - | 23 | 51 | 26 | - | Absent | 20,000 | 125 |
| (A-9) | C6FMA | CHMA | GMA | - | 18 | 50 | 32 | - | Absent | 21,000 | 122 |
| (A-10) | C6FMA | BEMA | GMA | - | 22 | 52 | 26 | - | Absent | 16,000 | 128 |
| (A-11) | C6FMA | EEMA | GMA | - | 8 | 47 | 45 | - | Absent | 14,000 | 152 |
| (A-12) | C6FMA | EEMA | GMA | - | 4 | 47 | 49 | - | Absent | 13,000 | 163 |
| (A-13) | α-ClC6FA | EEMA | GMA | - | 6 | 46 | 48 | - | Absent | 10,000 | 160 |
| (A-14) | C6FMA | EEMA | GMA | - | 23 | 52 | 25 | - | Present | 18,000 | 134 |
| (A-15) | C6FMA | EEMA | GMA | - | 43 | 47 | 9 | - | Present | 19,000 | 100 |
| (A-16) | C6FMA | EEMA | GMA | - | 42 | 39 | 19 | - | Present | 20,000 | 84 |
| (A-17) | C6FMA | EEMA | GMA | - | 38 | 39 | 23 | - | Present | 18,000 | 88 |
| (A-18) | C6FMA | EEMA | GMA | - | 11 | 52 | 37 | - | Present | 16,000 | 116 |
| (A-19) | C6FMA | EEMA | GMA | - | 6 | 55 | 39 | - | Present | 15,000 | 142 |
| (A-20) | C6FMA | EEMA | GMA | - | 30 | 41 | 29 | - | Present | 24,000 | 101 |
| (A-21) | C6FMA | EEMA | - | - | 30 | 70 | - | - | Present | 17,000 | 166 |
| (X-1) | C6FMA | EEMA | GMA | - | 44 | 31 | 25 | - | Absent | 29,000 | 64 |
| | | | | | | | | | | | |
| (X-2) | C6FMA | EEMA | GMA | - | 29 | 28 | 43 | - | Absent | 12,000 | 68 |

(continued)

| Polymer | Type of monomer constituting each unit | | | | Proportion of each unit (mol%) | | | | Use of chain transfer agent | Mass average molecular weight | Acid value (mgKOH/g) |
|---|---|---|---|---|---|---|---|---|---|---|---|
| | (u1) | (u2) | (u3) | (u4) | (u1) | (u2) | (u3) | (u4) | | | |
| (X-3) | C6FMA | - | GMA | t-BuMA | 33 | - | 14 | 53 | Absent | 20,000 | 125 |
| | | | | | | | | | | | |
| (X-4) | C6FMA | - | - | n-BuMA t-BuMA | 17 | - | - | 17 66 | Absent | 12,000 | 193 |
| (X-5) | C6FMA | - | - | t-BuMA | 15 | - | - | 85 | Absent | 13,000 | 256 |
| (X-6) | - | EEMA | GMA | - | - | 48 | 52 | - | Absent | 14,000 | 179 |
| (X-7) | C6FMA | - | GMA | - | 29 | - | 71 | - | Present | 22,000 | 0 |
| (X-8) | C6FMA | EEMA | GMA | - | 41 | 31 | 28 | - | Present | 20,000 | 69 |

(Photo-acid generator)

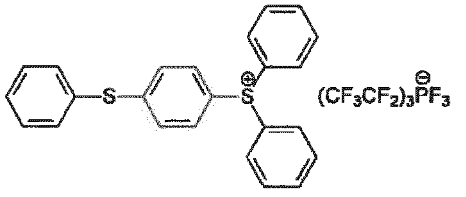

CPI210S

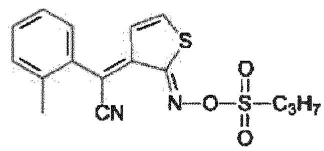

IRPAG103

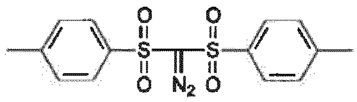

WPAG199

CPI210S: 4-(Phenylthio)phenyldiphenylsulfonium tris(heptafluoropropyl) trifluorophosphate (CPI (tradename)-210S, manufactured by Sun Apro Co., Ltd., absorption coefficient at a wavelength of 365 nm: 98 mL·$g^{-1}$·$cm^{-1}$).
IRPAG103: 2-[2-(Propylsulfonyloxyimino)thiophen-3(2H)-ylidene]-2-(2-methylphenyl)acetonitrile (manufactured by BASF, IRGACURE (trademark) PAG103, absorption coefficient at a wavelength of 365 nm: 11,000 mL·$g^{-1}$·$cm^{-1}$).
WPAG 199: Bis(p-toluenesulfonyl)diazomethane (WPAG-199, manufactured by Wako Pure Chemical Industries, Ltd., absorption coefficient at a wavelength of 365 nm: 151 mL·$g^{-1}$·$cm^{-1}$).
CPI 410S: Triarylsulfonium salt type photoacid generator (CPI (tradename)-410S, manufactured by Sun Apro Ltd., absorption coefficient at a wavelength of 365 nm: 4,300 mL·$g^{-1}$·$cm^{-1}$).

(Solvent)

PGMEA: Propylene glycol monomethyl ether acetate.

[Ex. 1]

3.0 g of the polymer (A-1), 0.3 g of CPI210S and 7.0 g of PGMEA were placed in a glass vial (20 mL), and thoroughly stirred to obtain a homogeneous solution. The solution obtained was filtered through a PTFE filter having a pore diameter of 0.50 μm to prepare a photosensitive resin composition. The composition was used to carry out each evaluation. Results are shown in Table 2.

[Ex. 2 to 36]

The photosensitive resin composition in each of Examples 2 to 36 was prepared in the same manner as in Ex. 1 except that the type of each component was changed. The composition was used to carry out each evaluation. In Ex. 25 to 36, NMD-W (TOKYO OHKA KOGYO CO., LTD.) was used as a developer. The results are shown in Table 2. Further, in Ex. 18, the polymer (A-6) was used as the polymer (A) and the polymer (X-6) was used as another component. In Ex. 35 and 36, (X-3) was used as the polymer B', (X-4) was used as the polymer B, and (X-6) was used as the polymer C'.

[Ex. 37]

A photosensitive resin composition of Ex. 37 was prepared in the same manner as in Ex. 1 except that the polymer (X-7) was used instead of the polymer (A-1). The polymer (X-7) in the composition had no unit (u2), and therefore the exposed portion of the photosensitive film was insoluble in the aqueous alkaline solution, whereby it is impossible to carry out development with an aqueous alkaline solution.
In the above evaluation of the resolution, after the exposure, the photosensitive film was subjected to PEB treatment at 120°C for 2 minutes, then developed with PGMEA for 30 seconds, and then post-baked at 200°C for 10 minutes to obtain a liquid repellent film. A hole pattern having a diameter of 6 μm was formed on the film.

[Table 2]

| Ex. | Copolymer | Photo-acid generator | Solvent | Contact angle of water (°) | Contact angle of PGMEA (°) | Resolution | Hole cross-sectional shape | Coating property | Fluorescence intensity |
|---|---|---|---|---|---|---|---|---|---|
| 1 | (A-1) | CPI210S | PGMEA | 107 | 51 | ○ | ○ | | 700 |
| 2 | (A-2) | CPI210S | PGMEA | 108 | 51 | ○ | ○ | ○ | 600 |
| 3 | (A-3) | CPI210S | PGMEA | 108 | 51 | ○ | ○ | | 700 |
| 4 | (A-4) | CPI210S | PGMEA | 106 | 54 | ○ | ○ | | 700 |
| 5 | (A-5) | CPI210S | PGMEA | 107 | 54 | ○ | ○ | | 700 |
| 6 | (A-6) | CPI210S | PGMEA | 105 | 12 | ○ | - | | 2,900 |
| 7 | (A-7) | CPI210S | PGMEA | 108 | 14 | ○ | - | | 1,700 |
| 8 | (A-8) | CPI210S | PGMEA | 105 | 54 | ○ | ○ | | 5,000 |
| 9 | (A-9) | CPI210S | PGMEA | 105 | 58 | ○ | ○ | | 2,400 |
| 10 | (A-10) | CPI210S | PGMEA | 108 | 58 | ○ | ○ | | 700 |
| 11 | (A-2) | IRPAG103 | PGMEA | 103 | 51 | ○ | ○ | | 66,000 |
| 12 | (A-2) | WPAG199 | PGMEA | 102 | 52 | ○ | - | | 6,200 |
| 13 | (A-2) | CPI410S | PGMEA | 104 | 51 | ○ | - | | 52,000 |
| 14 | (A-9) | IRPAG103 | PGMEA | 104 | 59 | ○ | ○ | | 66,000 |
| 15 | (A-10) | IRPAG103 | PGMEA | 106 | 60 | ○ | ○ | | 65,000 |
| 16 | (A-11) | CPI210S | PGMEA | 97 | 53 | ○ | ○ | ○ | 800 |
| 17 | (A-12) | CPI210S | PGMEA | 92 | 44 | ○ | ○ | ○ | 900 |
| 18 | (A-6)/(X-6) =7/3 | CPI210S | PGMEA | 105 | 12 | ○ | - | | 2,000 |
| 19 | (X-1) | CPI210S | PGMEA | 115 | 56 | × | - | | 600 |
| 20 | (X-2) | CPI210S | PGMEA | 108 | 50 | × | - | | 500 |
| 21 | (X-3) | CPI210S | PGMEA | 110 | 17 | × | - | | 2,100 |
| 22 | (X-4) | CPI210S | PGMEA | 108 | 12 | × | - | | 1,300 |
| 23 | (X-5) | CPI210S | PGMEA | 106 | 11 | × | - | | 1,100 |
| 24 | (X-6) | CPI210S | PGMEA | 79 | 29 | ○ | - | | 900 |

(continued)

| Ex. | Copolymer | Photo-acid generator | Solvent | Contact angle of water (°) | Contact angle of PGMEA (°) | Resolution | Holecross-sectional shape | Coating property | Fluorescence intensity |
|---|---|---|---|---|---|---|---|---|---|
| 25 | (A-13) | CPI210S | PGMEA | 96 | 48 | ○ | ○ | | 7,000 |
| 26 | (A-14) | CPI210S | PGMEA | 105 | 55 | ○ | ○ | ○ | 2,600 |
| 27 | (A-15) | CPI210S | PGMEA | 106 | 57 | ○ | - | ○ | 2,100 |
| 28 | (A-16) | CPI210S | PGMEA | 107 | 51 | ○ | - | ○ | 2,400 |
| 29 | (A-17) | CPI210S | PGMEA | 106 | 52 | ○ | - | ○ | 2,100 |
| 30 | (A-18) | CPI210S | PGMEA | 100 | 53 | ○ | ○ | ○ | 2,000 |
| 31 | (A-19) | CPI210S | PGMEA | 95 | 46 | ○ | ○ | ○ | 1,800 |
| 32 | (A-20) | CPI210S | PGMEA | 106 | 52 | ○ | - | ○ | 1,500 |
| 33 | (A-21) | CPI210S | PGMEA | 108 | 64 | ○ | - | ○ | 2,300 |
| 34 | (X-8) | CPI210S | PGMEA | 106 | 51 | × | - | ○ | - |
| 35 | (X-3)/(X-6) =3/7 | CPI-210S | PGMEA | 100 | 52 | ○ | - | - | 1,400 |
| 36 | (X-4)/(X-6) =3/7 | CPI-210S | PGMEA | 94 | 45 | ○ | - | - | 1,000 |
| 37 | (X-7) | CPI210S | PGMEA | 105 | 53 | × | - | - | 2,200 |

In Ex. 1 to 18 and 25 to 33 where the polymer (A) having the unit (u1) and the unit (u2) was used, it was possible to form a liquid repellent film having a predetermined pattern at a high resolution by development with an aqueous alkaline solution without performing PEB treatment. In particular, the fluorescence intensity in each of Ex. 1 to 10, Ex. 12 and Ex. 16 to 37 using a photo-acid generator having an absorption coefficient of at most 400 $mL \cdot g^{-1} \cdot cm^{-1}$, is lower than the fluorescence intensity in each of Ex. 11 and 13 to 15 using a photo-acid generator having an absorption coefficient of more than 400 $mL \cdot g^{-1} \cdot cm^{-1}$, and it was confirmed that such a film was more preferred as a liquid repellent film for a biochip. From the comparison between Ex. 2, 11, 12 and 26 using polymers having the same type of monomers and having a similar mass average molecular weight, it was confirmed that the influences on the liquid repellency, the resolution and the coating property by the use of the chain transfer agent were hardly observed.

In Ex. 19 to 24 and 34 using the polymer (X) satisfying at least one of (i) having a proportion of the unit (u2) being less than 35 mol%, (ii) containing no unit (u2), and (iii) having a unit having an acid-dissociable group different from the unit (u2), it was impossible to form a liquid repellent film having a predetermined pattern at a high resolution by development with an aqueous alkaline solution.

Here, in Ex. 1, evaluation was carried out by changing the developer used for evaluating the hole cross-sectional shape from a 2.38 mass% tetramethylammonium hydroxide aqueous solution to AD-10 (manufactured by TAMA CHEMICALS CO., LTD.) and NMD-W (TOKYO OHKA KOGYO CO., LTD.) As a result, the hole cross-sectional shape was smooth as compared with the case of using the aqueous 2.38 mass% tetramethylammonium hydroxide solution, and in particular, it was smooth in the case of using NMD-W. AD-10 contains a nonionic surfactant and has a surface tension of 44 mN/m, and the 2.38 mass% tetramethylammonium hydroxide aqueous solution has a surface tension of 72 mN/m. NMD-W contains a surfactant and has a surface tension of 42 mN/m. The surface tension was measured by means of a plate method (measurement temperature: 25°C., measurement apparatus: CBVP-Z, manufactured by Kyowa Interface Science Co., Ltd.)

In Ex. 37 using the polymer (X-7) having no unit (u2) and having the unit (u1) and the unit (u3), it was impossible to form a liquid repellent film having a predetermined pattern at a high resolution, by development with an aqueous alkaline solution. When development with PGMEA was carried out for 30 seconds after PEB treatment at 120°C for 2 minutes, instead of the development with an alkali aqueous solution, a hole pattern with a diameter of 6 μm was obtained.

INDUSTRIAL APPLICABILITY

The polymer and the photosensitive resin composition of the present invention are useful for producing e.g. a member or device having a patterned liquid repellent film, such as a biochip having a patterned liquid repellent film, a pixel forming substrate for a patterned liquid repellent bank material or an electrowetting device having a patterned liquid repellent insulating film.

The entire disclosures of Japanese Patent Application No. No. 2016-007734 filed on January 19, 2016, Japanese Patent Application No. 2016-087044 filed on April 25, 2016 and Japanese Patent Application No. 2016-136414 filed on July 8, 2016 including specifications, claims, drawings and summaries are incorporated herein by reference in their entireties.

REFERENCE SYMBOLS

10: Substrate, 12: photosensitive film, 14: exposed portion, 16: latent image, 18: liquid repellent film, 20: mask, 22: light source

## Claims

1. A photosensitive resin composition for a biochip, which comprises the following polymer (A), or comprises the following polymer (B) and the following polymer (C), wherein the proportion of the following unit (u2) is from 35 to 97 mol% to the total number of units constituting the composition,

Unit (u2): a unit represented by the following formula (II):

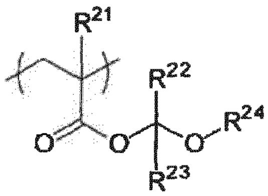

(II)

wherein $R^{21}$ is a hydrogen atom or a methyl group, $R^{22}$ is an alkyl group or a cycloalkyl group, $R^{23}$ is a hydrogen atom, an alkyl group or a cycloalkyl group, $R^{24}$ is an alkyl group in which one or more of hydrogen atoms may be substituted, a cycloalkyl group in which one or more of hydrogen atoms may be substituted, or an aralkyl group in which one or more of hydrogen atoms may be substituted, and $R^{22}$ and $R^{24}$ may be linked with each other to form a cyclic ether,

Polymer (A): a polymer having a unit (u1) which has an organic group having at least one fluorine atom, and the unit (u2),

Polymer (B): a polymer having the unit (u1) which has an organic group having at least one fluorine atom, other than the polymer (A),

Polymer (C): a polymer having the unit (u2), other than the polymer (A).

**2.** The photosensitive resin composition for a biochip according to Claim 1, wherein the unit (u1) is a unit represented by the following formula (I):

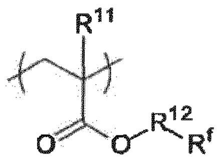

(I)

wherein $R^{11}$ is a hydrogen atom, a methyl group or a halogen atom, $R^{12}$ is an alkylene group, $R^f$ is a $C_{4-6}$ perfluoroalkyl group or a $C_{4-6}$ perfluoroalkyl group having an etheric oxygen atom between the carbon atoms.

**3.** The photosensitive resin composition for a biochip according to Claim 1 or 2, which comprises the following polymer (A'), comprises the following polymer (B') and the following polymer (C'), comprises the following polymer (B') and the above polymer (C), comprises the above polymer (B) and the following polymer (C'), or comprises the above polymer (B), the above polymer (C) and the following polymer (D),

Polymer (A'): a polymer having the above unit (u1), the above unit (u2) and the following unit (u3),

Polymer (B'): a polymer having the above unit (u1) and the following unit (u3), other than the polymer (A'),

Polymer (C'): a polymer having the above unit (u2) and the following unit (u3), other than the polymer (A'),

Polymer (D): a polymer having the following unit (u3), other than the polymer (A'), the polymer (B') and the polymer (C'),

Unit (u3): a unit having a cyclic ether.

**4.** The photosensitive resin composition for a biochip according to Claim 3, wherein the unit (u3) is a unit represented by the following formula (III):

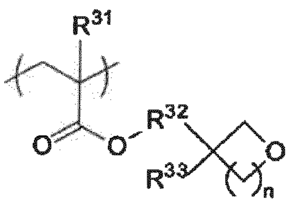

(III)

wherein $R^{31}$ is a hydrogen atom or a methyl group, $R^{32}$ is an alkylene group, $R^{33}$ is a hydrogen atom or an alkyl group, and n is 0 or 1.

**5.** The photosensitive resin composition for a biochip according to Claim 3 or 4, which contains the above polymer (A').

**6.** A polymer comprising a unit (u1) which has an organic group having at least one fluorine atom, and a unit (u2) represented by the following formula (II), wherein the proportion of the unit (u2) is from 35 to 97 mol% to the total units,

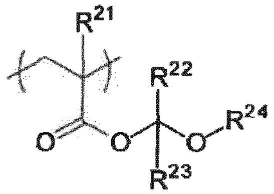

(II)

wherein $R^{21}$ is a hydrogen atom or a methyl group, $R^{22}$ is an alkyl group or a cycloalkyl group, $R^{23}$ is a hydrogen atom, an alkyl group or a cycloalkyl group, $R^{24}$ is an alkyl group in which one or more of hydrogen atoms may be substituted, a cycloalkyl group in which one or more of hydrogen atoms may be substituted, or an aralkyl group in which one or more of hydrogen atoms may be substituted, and $R^{22}$ and $R^{24}$ may be linked to form a cyclic ether.

**7.** The polymer according to Claim 6, wherein the above unit (u1) is a unit represented by the following formula (I):

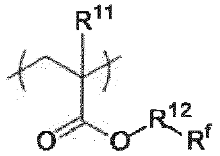

(I)

wherein $R^{11}$ is a hydrogen atom, a methyl group or a halogen atom, $R^{12}$ is an alkylene group, $R^f$ is a $C_{4-6}$ perfluoroalkyl group or a $C_{4-6}$ perfluoroalkyl group having an etheric oxygen atom between the carbon atoms.

**8.** The polymer according to Claim 6 or 7, wherein the proportion of the above unit (u2) is from 35 to 97 mol% to the total units of the polymer.

**9.** The polymer according to any one of Claims 6 to 8, which further contains a unit (u3) having a cyclic ether.

**10.** The polymer according to Claim 9, wherein the above unit (u3) is a unit represented by the following formula (III):

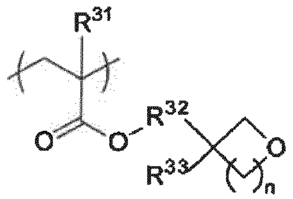

(III)

wherein $R^{31}$ is a hydrogen atom or a methyl group, $R^{32}$ is an alkylene group, $R^{33}$ is a hydrogen atom or an alkyl group, and n is 0 or 1.

**11.** The polymer according to Claim 9 or 10, wherein the proportion of the above unit (u1) is from 3 to 50 mol%, the proportion of the above unit (u2) is from 35 to 75 mol%, and the proportion of the above unit (u3) is from 1 to 60 mol%, to the total units of the polymer.

**12.** The polymer according to any one of Claims 6 to 11, which has a group represented by the following formula (IV), at either one or both of main chain terminals,

$$-S-CR^1R^2R^3 \qquad (IV)$$

wherein $R^1$ and $R^2$ are each independently a hydrogen atom or an alkyl group in which one or more of hydrogen atoms may be substituted, $R^3$ is an alkyl group in which one or more of hydrogen atoms may be substituted, a cycloalkyl group in which one or more of hydrogen atoms may be substituted, an aryl group in which one or more of hydrogen atoms may be substituted, or a heteroaryl group in which one or more of hydrogen atoms may be

substituted, and two or three of $R^1$ to $R^3$ may be linked with one another to form a ring structure.

**13.** The photosensitive resin composition for a biochip according to any one of Claims 1 to 5, which further contains a photo-acid generator.

**14.** A method for forming a liquid repellent film, which comprises coating the surface of a substrate with the photosensitive resin composition for a biochip as defined in Claim 13 to form a photosensitive film, exposing the photosensitive film to form a latent image having a predetermined pattern, and developing the photosensitive film having the latent image formed, with an aqueous alkaline solution, to form the liquid repellent film having the predetermined pattern.

**15.** A process for producing a biochip having a lyophilic substrate and a liquid repellent film which is provided on the surface of the lyophilic substrate and has a plurality of pores or grooves penetrating in the thickness direction, which comprises coating the surface of the lyophilic substrate with the photosensitive resin composition as defined in Claim 13 to form a photosensitive film, exposing a site corresponding to the pores of the photosensitive film, and developing the photosensitive film exposed, with an aqueous alkaline solution, to form the above liquid repellent film.

Fig. 1

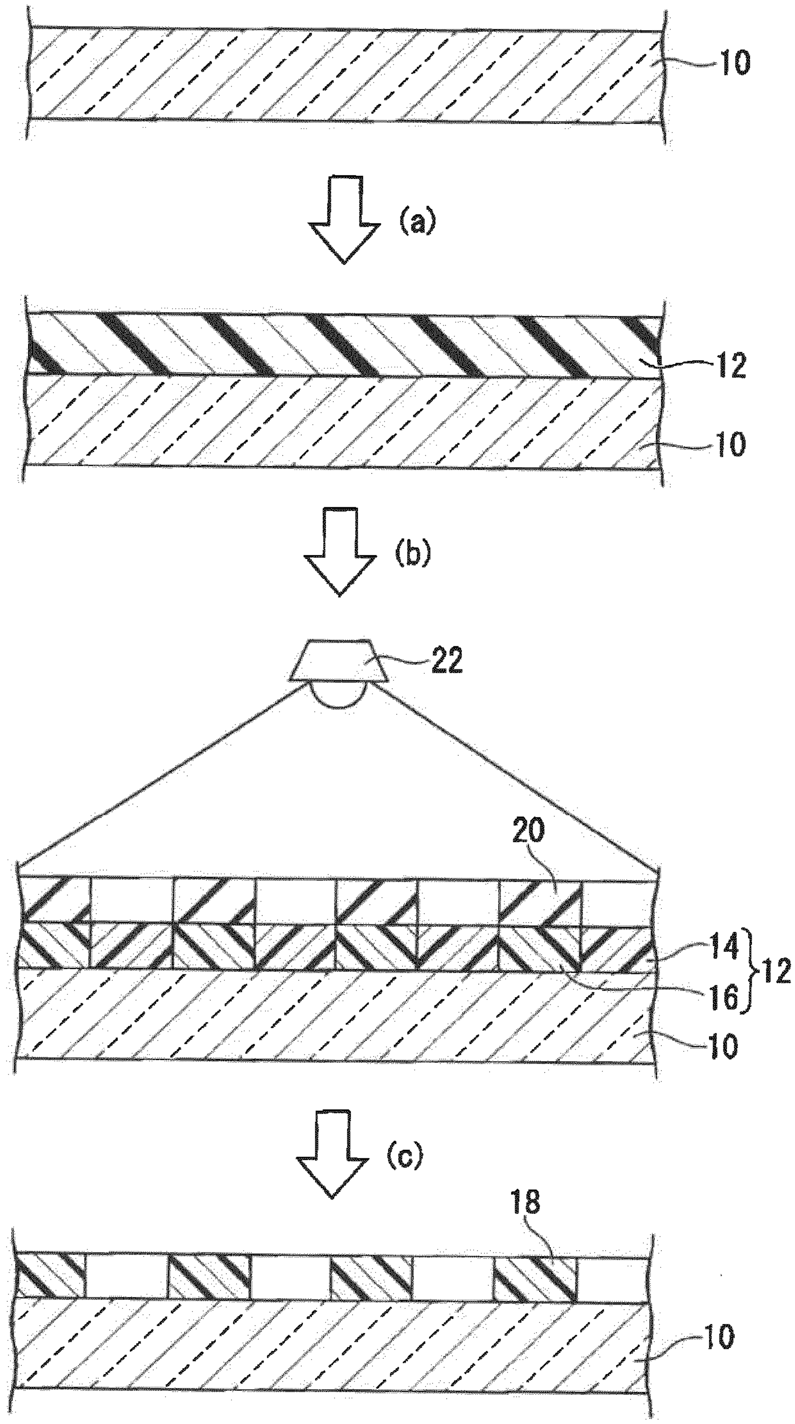

## INTERNATIONAL SEARCH REPORT

International application No.
PCT/JP2017/001602

A. CLASSIFICATION OF SUBJECT MATTER
*C08F220/24*(2006.01)i, *C08F220/26*(2006.01)i, *C08K3/16*(2006.01)i, *C08K5/42*(2006.01)i, *C08L33/14*(2006.01)i, *C12M1/00*(2006.01)i, *G03F7/039*(2006.01)i

According to International Patent Classification (IPC) or to both national classification and IPC

B. FIELDS SEARCHED

Minimum documentation searched (classification system followed by classification symbols)
C08F220/24, C08F220/26, C08K3/16, C08K5/42, C08L33/14, C12M1/00, G03F7/039

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2017 |
| Kokai Jitsuyo Shinan Koho | 1971-2017 | Toroku Jitsuyo Shinan Koho | 1994-2017 |

Electronic data base consulted during the international search (name of data base and, where practicable, search terms used)
JSTPlus/JMEDPlus/JST7580(JDreamIII), CAplus/REGISTRY(STN)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2015-072455 A (JSR Corp.), 16 April 2015 (16.04.2015), claims; paragraphs [0042], [0083] to [0095], [0099] & KR 10-2015-0027700 A | 6-12<br>1-5,13-15 |
| X<br>Y<br>A | JP 2009-191151 A (Shin-Etsu Chemical Co., Ltd.), 27 August 2009 (27.08.2009), claims; paragraphs [0019], [0029], [0057] to [0062], [0068], [0188] & US 2009/0208873 A1 claims; paragraphs [0033], [0043], [0060] to [0063], [0068], [0192] & EP 2090598 A1 & KR 10-2009-0088330 A & TW 200936616 A | 6,8-12<br>1,3-5,13-15<br>2,7 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 04 April 2017 (04.04.17) | 18 April 2017 (18.04.17) |

| Name and mailing address of the ISA/ | Authorized officer |
|---|---|
| Japan Patent Office<br>3-4-3,Kasumigaseki,Chiyoda-ku,<br>Tokyo 100-8915,Japan | <br>Telephone No. |

Form PCT/ISA/210 (second sheet) (January 2015)

**INTERNATIONAL SEARCH REPORT**

International application No.
PCT/JP2017/001602

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2011-184517 A (Daikin Industries, Ltd.), 22 September 2011 (22.09.2011), claims; paragraph [0002] (Family: none) | 1-5,13-15 |
| Y | JP 2008-297344 A (Nippon Paint Co., Ltd.), 11 December 2008 (11.12.2008), claims; paragraphs [0001], [0002] (Family: none) | 1-5,13-15 |
| Y | JP 2008-274143 A (Tokyo Ohka Kogyo Co., Ltd.), 13 November 2008 (13.11.2008), claims & US 2008/0268376 A1 claims & TW 200912539 A | 1-15 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2012121310 A
- WO 2011081149 A
- WO 2013129503 A
- WO 2006129800 A
- JP 2004359616 A
- JP 2010024381 A
- JP 2016007734 A
- JP 2016087044 A
- JP 2016136414 A